# EUROPEAN PATENT SPECIFICATION

(11) **EP 1 416 780 B1**
(45) Date of publication and mention of the grant of the patent: **01.08.2007**
(21) Application number: 03256527.7
(22) Date of filing: 16.10.2003
(51) Int. Cl.: H05K 7/02

(54) **LGA package socket**
Fassung und Verbinder für einen LGA Baustein
Boîtier de support et connecteur pour un composant LGA

(30) Priority: 31.10.2002 JP 2002317646; 27.12.2002 JP 2002379635
(43) Date of publication of application: 06.05.2004
(73) Proprietor: Tyco Electronics AMP K.K., Kawasaki, Kanagawa 213-8535 (JP)
(72) Inventor: Shirai, Hiroshi, Tokorozawa-shi Saitama-ken, 359-0021 (JP); Hashimoto, Shinichi, Kawasaki-shi Kanagawa-ken, 213-0013 (JP); Inoue, Masashi, Yokohama-shi Kanagawa-ken, 235-0045 (JP)
(74) Representative: Johnstone, Douglas Ian

(56) References cited:
- EP-A- 1 006 618
- US-A- 5 688 140
- US-A- 6 086 387

## Description

The present invention relates to LGA package sockets for forming an electrical connection under pressure between an LGA package placed on an insulative housing and electric contacts accommodated in the insulative housing, and for forming an electrical connection between the LGA package and a printed circuit board (also referred to herein as a printed board).

Conventionally, various types of IC package sockets for attaching IC packages have been known. Each IC package has a large number of electric contacts which are arranged in a matrix-like array. The IC packages are classified as PGA (pin grid array) packages, BGA (ball grid array) packages, and LGA (land grid array) packages, depending on the shape of the electric contact portion of the electric contact. In the IC packages of every type, a large number of electric contacts are brought into contact with the other electric contacts accommodated in the housing of the socket in order to establish electrical connections therebetween, which typically causes a large contact pressure.

In cases that such contact pressure is exerted on the socket, various measures are taken for providing a sufficient strength to prevent deformation of the socket. As an example of such sockets, there is known a PGA package socket having an insulative housing reinforced by over-molding a thin metallic frame member with the insulating resin from which the housing is formed (Unexamined Published Japanese Patent Application No. 2000-173735 (FIG. 1, FIG. 2), hereinafter referred to as Patent Reference 1).

On the other hand, for an LGA package socket which exerts a force in a vertical direction that is, in the direction substantially perpendicular to the printed board, a pair of metal reinforcements are used to prevent deformation of the insulative housing. The pair of metal reinforcements is adapted to clamp the LGA package and the LGA package socket fitted with the LGA package together from opposite sides, that is, from both the front and back surface sides, of a mount board to which the socket is fitted. This metal reinforcement is constituted by a loading plate or heat sink disposed on the LGA package placed on the socket, and a board-warpage restraint plate disposed under the mount board.

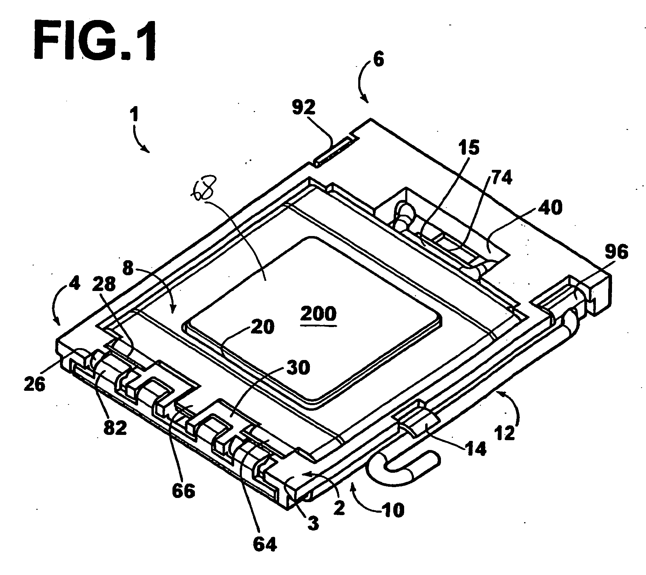

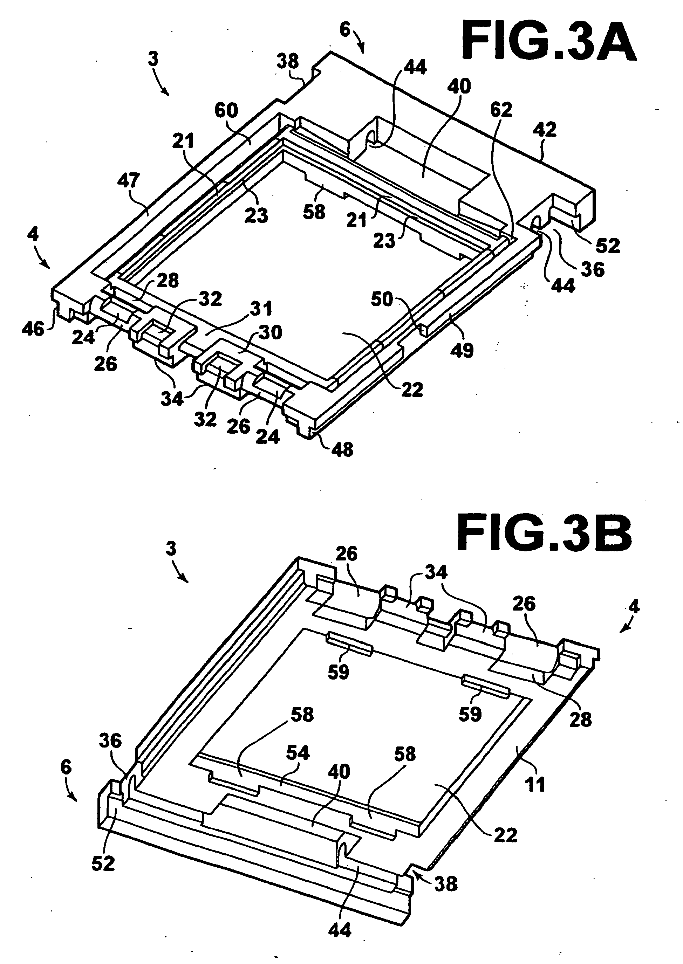

A lever may be used to connect the large number of electric contacts of the IC package with other electric contacts of the socket and to maintain the electrical connections (Unexamined Published Japanese Utility Model Application No. 2-86090 (FIG. 1, FIG. 3), hereinafter referred to as Patent Reference 2). This lever is adapted to be engaged with a protrusion or elastic interlocking element integrally formed with the resin housing of the socket, and then locked to hold the electrical connections between the IC package and the socket (Patent Reference 2).

In the case of the housing formed by over-molding the metal frame member by insulating resin as with the foregoing conventional art disclosed in Patent Reference 1, the peripheral edges of the housing may be reinforced for connecting with a PGA package. With this PGA package socket, electrical connections are formed by horizontally moving a slide cover having thereon a PGA package by use of a cam or a lever. Therefore the housing would not be subjected to a large vertical force. Directions of force exerted on a socket are thus different for each package. Though the socket of the type disclosed in Patent Reference 1 is suitable for PGA packages, it lacks sufficient strength for use with LGA packages wherein a large vertical load is generated when an LGA package is pressed from above the socket, because the underside of the housing is not reinforced.

Further, the sockets of the type wherein an LGA package, an LGA package socket, and a mount board are locked together with a screw as in the LGA package socket of the foregoing prior art have a number of problems as mentioned below. That is, a plate or heat sink and a board-warpage restraint plate are passed through by a screw and tightened by a nut at each corner thereof to prevent deformation of a socket, which require a larger footprint on a printed board than that actually occupied by the socket itself. With this socket, therefore, the deformation of the socket is prevented, but the size is large, a large number of parts such as screws are used, and an installation task is complicated. In addition, it becomes also necessary to form apertures to pass the screws through the printed board on the periphery of the socket. There is also another scheme wherein the configuration of the socket is simplified, for example, by disposing an LGA package and socket between a heat sink and a printed board, and the socket is directly screwed to the printed board. However, this raises a problem that the warpage in the printed board become larger.

When the lever is locked by a protrusion or elastic interlocking element that is formed integrally with the socket (resin housing), there is a problem that the socket is poor in durability. This is because the protrusion or elastic interlocking element is apt to wear out due to friction with the lever by the engagement operation of the lever, since it is made of resin. However, forming this interlocking element as a separate metal member causes another problem in that the number of parts and the costs increase.

When the LGA package is disposed on the socket and pressed by the cover member to form electrical connections, if the housing of the socket deforms, the flatness of the electric contact array may be distorted. As a result, good electrical connections between the LGA package contacts and the insulative housing contacts are not necessarily ensured. Further, there is another problem that when connecting, the force applied to the lever for actuation is not efficiently transferred for connection because the force is absorbed by the reformation of the housing.

In view of the foregoing problems, an object of the present invention is to provide an LGA package socket which has sufficient strength to prevent deformation of the housing of the socket when the socket is fitted to the LGA package and which has a simple construction that allows easy installation.

Another object of the present invention is to provide an LGA package socket in which sufficient strength is ensured without increasing the size of the footprint of the socket.

Still another object of the present invention is to provide a durable LGA package socket.

An LGA package socket of the invention comprises a rectangular insulative housing having a large number of cavities each of which accommodates an electric contact, a cover member pivotally mounted on a first end of the insulative housing, and a lever pivotally mounted on a second end opposite the first end of the insulative housing, wherein when the cover member is closed, the LGA package placed on the insulative housing is pressed against the electric contacts to form electrical connections and a free end of the closed cover member is locked by the lever, the LGA package socket being characterized in that the lever is pivotally supported on the second end, a metallic reinforcing member extending between the first end and the second end is provided on the underside of the insulative housing, and the LGA package and the insulative housing are held in close association with one another between the metallic reinforcing member and the cover member.

In accordance with the present invention, it is contemplated that the cover member has a bearing tongue element on the first end, the insulative housing has a shaft on the first end, and the cover member is attached to the insulative housing by engaging the bearing tongue element with the shaft of the insulative housing.

The aforementioned metallic reinforcing member may comprise a generally L-shaped retaining element on the first end, by which the metallic reinforcing member is engaged with the insulative housing.

Preferably, the cover member and the metallic reinforcing member are engaged with each other via the shaft of the insulative housing.

The metallic reinforcing member may be formed integrally with an interlocking portion which serves to lock the lever with the lever and cover member engaged.

Further, the metallic reinforcing member may be formed as a one-piece component which extends along the entire periphery of the insulative housing, or the metallic reinforcing member may be formed by two members formed along two sides each of which extends between the first end and the second end.

In one aspect of the invention, the cover member may be pivotally supported by the metallic reinforcing member on the one side of the insulative housing. In this case, the cover member may have a rotary shaft and the reinforcing member may have a rotary-shaft bearing, or vice versa.

Further, a construction may be adopted wherein each of the cover member and the reinforcing member has an aperture for a rotary shaft, and the cover member is pivotally mounted to the reinforcing member by a metallic shaft member which is separate from the metallic reinforcing member.

An LGA package socket according to another aspect of the invention comprises a rectangular insulative housing having a large number of cavities each of which accommodates an electric contact, a metallic reinforcing member for accommodating the insulative housing, a cover member pivotally mounted on a first end of the metallic reinforcing member, and a lever pivotally mounted on a second end opposite the first end of the metallic reinforcing member, wherein when the cover member is closed, the insulative housing and the LGA package placed on the insulative housing are held between the metallic reinforcing member and the cover member while a free end of the closed cover member is locked by the lever, with the result that the LGA package is electrically connected with the electric contacts.

A construction may be adopted wherein the lever comprises a locking portion for locking a free end of the cover member, a rotatably-supported portion which is rotatably supported by the metallic reinforcing member on both sides of the locking portion, and an actuating portion bent at a predetermined angle away from the rotatably-supported portion so that the actuating portion can be engaged with an interlocking protrusion of the metallic reinforcing member, wherein the shaft from the rotatably supported portion on the actuating portion side to the actuating portion has a length sufficient to allow the displacement of the shaft associated with disengaging the actuating portion from the interlocking protrusion, and a space for accommodating the displacement is provided at a position located on the side opposite at least the actuating portion of the shaft.

Further, a construction may be adopted wherein the angle between the actuating portion and the shaft-bearing portion is set as a right angle and the angle between the shaft and the actuating portion set as an obtuse angle, with the result that the space is provided at a position located on the side opposite to the actuating portion of the shaft.

A construction may be adopted wherein the insulative housing has a plurality of swaging portions, the metallic reinforcing member has an engaging portion adapted to be engaged with the swaging portion, and the insulative housing is fixed to the metallic reinforcing member by swaging the swaging portions.

Further, a construction may be adopted wherein the cover member comprises an opening for exposing a part of the LGA package, a convex surface which extends from the external edges of the cover member to the opposed end edges of the opening and is formed to curve towards the LGA package side, and a pressure-applying point, which is caused to press the LGA package when the cover member is closed, at the most protruded portion of each curved surface.

The curved surface may be designed to have progressively increasing curvatures and have the largest curvature at the pressure-applying point. As for the curvatures, the radius of curvature at the pressure-applying point having the largest curvature may be set to be 213 mm, and the radius of curvature at the peripheral area having a smaller curvature may be set to be 788 mm.

The LGA package socket of the present invention comprises a metallic reinforcing member which is disposed on the underside of the insulative housing, extends between the first end and the second end, pivotally supports a lever on the second end, and is engaged with the housing at the first end. The LGA package socket of the invention is configured such that the LGA package and the insulative housing are held in close association with one another between the metallic reinforcing member and the cover member, which produces effects as follows.

That is, since the LGA package is held between the metallic reinforcing member and the cover member even when a force for connecting the LGA package to the housing of the socket is applied, the force exerted on the socket is supported by the metallic reinforcing member, which can provide the LGA package socket with sufficient strength to withstand the load of connection, with no possibility of deformation of the LGA socket. In addition, the metallic reinforcing member can be attached to the housing easily without having to use screws. Further, the metallic reinforcing member can be attached within the range of the footprint of the socket, which permits the size of the footprint to fit within the range of the socket area while ensuring the strength thereof.

When the interlocking portion of the lever is formed integrally with the metallic reinforcing member, the interlocking potion is hardly worn due to lever operations, and therefore a LGA package socket having a high wear resistance and good durability is provided.

When the metallic reinforcing member is formed as a one-piece component which extends along the entire periphery of the insulative housing, the insulative housing is held entirely around the circumference thereof. This contributes to powerful resistance against deformation of the insulative housing. Meanwhile, as the metallic reinforcing member is a one-piece component, it can be easily attached to the housing, with the result that an easy-to-construct LGA package socket is provided.

When the metallic reinforcing member is formed by two members which are attached to the insulative housing along two sides thereof, each of which extends between the first end and the second end, warpage of the housing is prevented by the metallic reinforcing member. In addition, since the metallic reinforcing member does not extend along the entire periphery of the housing, the LGA package socket is made lighter as a whole.

When the cover member is configured to be pivotally supported by the metallic reinforcing member on the first end of the insulative housing, excessive load is not imposed to even the first end of the housing and therefore the deformation of the housing can be prevented.

Further, when both the cover member and the metallic reinforcing member respectively have apertures for the rotary shaft, and the cover member is constituted by a metallic shaft member separated from the metallic reinforcing member and pivotally supported to a metallic reinforcing member, the configurations of the cover member and metallic reinforcing member are simplified.

In the socket according to another aspect of the invention, the insulative housing and the LGA package placed on the insulative housing are held between the metallic reinforcing member and the cover member by closing the cover member, and a free end of the closed cover member is engaged with the lever to electrically connect the electric contacts with the LGA package, which produces effects as follows.

That is, the cover member is directly engaged with the lever without the intermediary of the insulative housing, which prevents deformation of the insulative housing. Accordingly, connections between electric contacts are formed smoothly, and the reliability of the electrical connection is improved. In addition, the actuating force is not absorbed due to deformation of the insulative housing. Thus, impairments in the reliability of the electrical connections, due to the lack of load to bias the LGA package against the electric contacts, can be prevented.

When the shaft of the lever from the rotatably supported portion on the actuating portion side to the actuating portion has a length sufficient to allow the displacement of the shaft associated with disengaging the actuating portion from the interlocking protrusion, and a space for accommodating the displacement is provided at a position located on the side opposite at least the actuating portion of the shaft, the displaceability of the shaft when the lever is disengaged is enhanced, which enables a reduction in the force required to disengage the lever, and in turn the disengaging facility of the lever is improved.

When the angle between the actuating portion and the shaft-supporting portion is set as a right angle, the angle between the shaft and the actuating portion is set as an obtuse angle, and accordingly a space is formed on the side opposite to the actuation portion of the shaft, the space is ensured to be formed irrespective of the structure located on the side opposite the actuating portion of the shaft. This enhances the disengaging facility of the lever.

Further, the insulative housing may have a plurality of swaged portions, and the metallic reinforcing member may have an engagement to be engaged with the swaged portions. When the insulative housing is fixed to the metallic reinforcing member by swaging the swaged portions, fixing is achieved by simply swaging, with the result that the construction of the metallic reinforcing member can be simplified without impairing the rigidity of the metallic reinforcing member.

Further, when the cover member has a convex surface which is curved towards the LGA package side, and has a pressure-applying portion, which is adapted to press the LGA package when the cover member is closed, at the most protruded portion on each curved surface, projection of the cover member beyond the upper surface of the LGA packages can be avoided even if the cover member is deformed upward by a load when the load is applied to the LGA package. Therefore, even if another component, for example, a heat sink or the like, is mounted on the upper surface of the LGA package, disengagement of such a component, by deformation of the cover member lifting the component upward, is prevented.

Further, when the curved surface is designed to have progressively increasing curvatures and have the largest curvature at the pressure-applying point, projection of the cover member beyond the upper surface of the LGA packages can be avoided and the LGA package can be surely pressed by the pressure-applying point having a large radius of curvature. That is, by forming the pressure-applying portions with two curvatures that are different from one another, load can be applied without exceeding beyond the upper surface of the LGA package during pressing and without changing the pressure-applying points.

The invention will now be described by way of example only with reference to the accompanying drawings in which:
FIG. 1 is a perspective view from above illustrating an LGA package socket according to a first embodiment of the invention, with an LGA package fitted.
FIG. 2 is a perspective view from below illustrating the LGA package socket of FIG. 1.
FIGS. 3A and FIG. 3B illustrate an outer housing used for the LGA package socket of FIG. 1, FIG. 3A being a perspective view from above and FIG. 3B being a perspective view from below.
FIG. 4 is a perspective view from above illustrating an inner housing used for the LGA package socket of FIG. 1.
FIG. 5 is a perspective view from below illustrating an inner housing used for the LGA package socket of FIG. 1.
FIGS. 6A and 6B illustrate a cover member used for the LGA package socket of FIG. 1, FIG. 6A being a perspective view from above, and FIG. 6B being a perspective view from above taken along another direction.
FIG. 7 is a perspective view from above illustrating a metallic reinforcing plate used for the LGA package socket of FIG. 1.
FIG. 8 is a perspective view of a lever used for the LGA package socket of FIG. 1.
FIG. 9 is a perspective view from above illustrating the LGA package socket according to the first embodiment, with the cover member open.
FIG. 10 is a perspective view, from above taken along another direction, of the LGA package socket according to the first embodiment, with the cover member open.
FIGS. 11A to 11E illustrate an outer housing used for an LGA package socket according to a second embodiment of the invention, FIG. 11A being a plan view, FIG. 11B being a left side view, FIG. 11C being a right side view, FIG. 11D being a front view, and FIG. 11E being a rear view.
FIGS. 12A to 12D illustrate the outer housing of FIGS. 11A to 11E, FIG. 12A being a bottom view, FIG. 12B being a sectional view taken along line 12B-12B of FIG. 12A, FIG. 12C being a sectional view taken along line 12C-12C of FIG. 12A, and FIG. 12D being a sectional view taken along line 12D-12D of FIG. 12A.
FIGS. 13A to 13E illustrate one reinforcing plate used for the second embodiment of the invention, FIG. 13A being a plan view, FIG. 13B being a front view, FIG. 13C being a bottom view, FIG. 13D being a rear view, and FIG. 13E being a side view taken along arrow 13E of FIG 13B.
FIGS. 14A to 14E illustrate the other reinforcing plate used for the second embodiment of the invention, FIG. 14A being a plan view, FIG. 14B being a front view, FIG. 14C being a bottom view, FIG. 14D being a rear view, and FIG. 14E being a side view taken along arrow 14E of FIG. 14B.
FIGS. 15A to 15D illustrate the LGA package socket according to the second embodiment of the invention, FIG. 15A being a plan view, FIG. 15B being a front view, FIG. 15C being a side view taken along arrow 15C of FIG. 15A, and FIG. 15D being a side view taken along arrow 15D of FIG. 15A.
FIG. 16 is a bottom view of the LGA package socket according to the second embodiment of the invention.
FIG. 17 is a sectional view of the LGA package socket taken along line 17-17 of FIG. 15A.
FIGS. 18A to 18D illustrate an LGA package socket according to a third embodiment of the invention, FIG. 18A being a view seen from one side, FIG. 18B being a plan view, FIG. 18C being a partially broken away view seen from another side, and FIG. 18D being a front view.
FIGS. 19A to 19E illustrate a metallic reinforcing plate of the LGA package socket in FIGS. 18A-18D, FIG. 19A being a plan view, FIG. 19B being a view seen from one side, FIG. 19C being a view seen from the other side, FIG. 19D being a partial sectional view taken along line 19E-19E of FIG. 19A.
FIGS. 20A to 20G illustrate a cover member used for the LGA package socket in FIGS. 18A-18D, FIG. 20A being a plan view, FIG. 20B being a rear view, FIG. 20C being a view seen from one side, FIG. 20D being a view seen from the other side, FIG. 20E being a sectional view taken along line 20e-20e in FIG. 20A, FIG. 20F being a front view, and FIG. 20G being a sectional view taken along line 20g-20g in FIG. 20A.
FIGS. 21A to 21C illustrate an insulative housing used for the LGA package socket of FIGS. 18A-18D, FIG. 21A being a plan view, FIG. 21B being a side view, and FIG. 21C being a front view.
FIGS. 22A and 22B illustrate the housing placed on but not yet attached to the reinforcing plate, FIG. 22A being a bottom view, and FIG. 22B being a side view.
FIGS. 23A and 23B illustrate the housing completely secured to the reinforcing plate, FIG. 23A being a bottom view, and FIG. 23B being a side view.
FIGS. 24A and 24B illustrate an essential part of the LGA package socket of FIGS. 18A to 18D, FIG. 24A being a sectional view with a suction cap attached, and FIG. 24B being a sectional view with a suction cap removed and the LGA package not yet attached.
FIG. 25 is a side view of an assembly of an LGA package socket with a heat sink mounted thereon.
FIG. 26 is a transparent side view of an essential part of the LGA package socket showing the state that the cover member of the LGA package socket presses the LGA package socket.

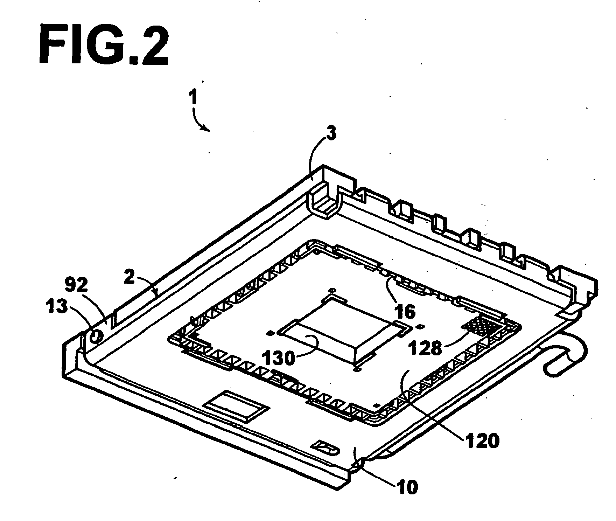

In the following, preferred embodiments of the LGA package socket (hereinafter, simply referred to as "socket") in accordance with the present invention will be described in detail with reference to the accompanying drawings. FIG. 1 is a perspective view from above of an LGA package socket 1 according to a first embodiment of the invention with an LGA package fitted therein, and FIG. 2 is a perspective view from below of the socket 1.

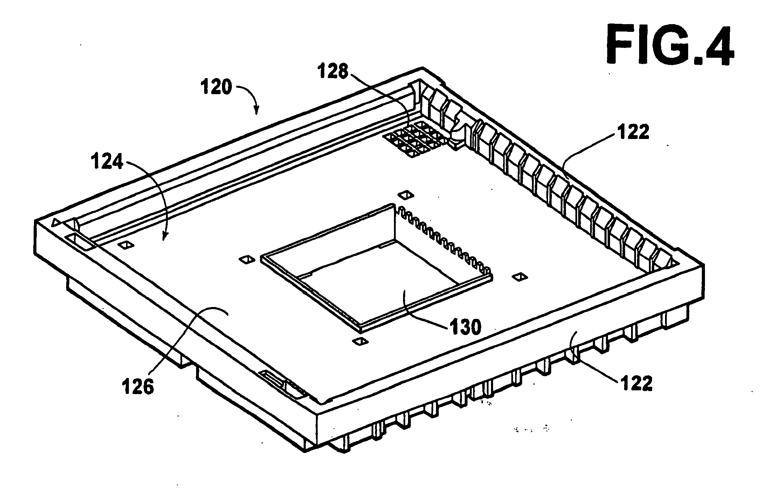

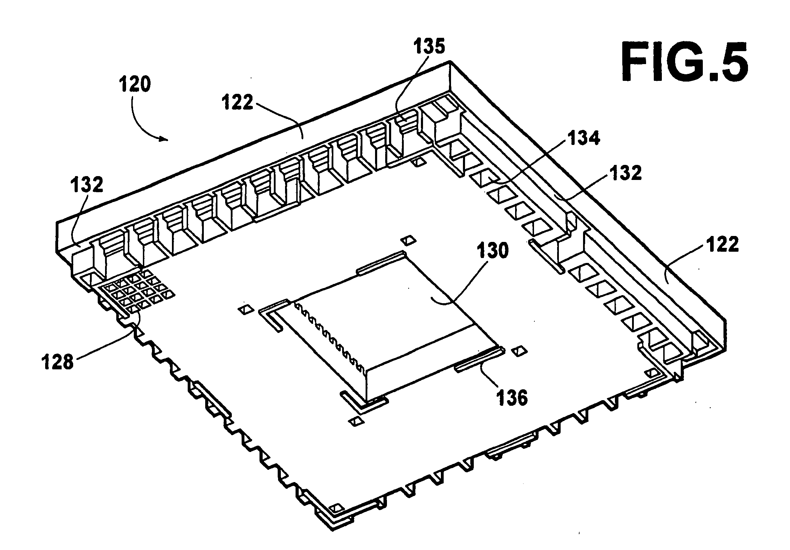

First, the general structure of the socket will be described with reference to FIG. 1. The socket 1 comprises an insulative housing 2 molded from resin or the like (hereinafter, simply referred to as "housing"), a cover member 8 pivotally mounted to the housing 2 on the side of a first end 4 thereof and having therein a rectangular opening 68, a metallic reinforcing plate (hereinafter, simply referred to as "reinforcing plate") 10 attached to the underside of the housing 2, and a lever 12 pivotally supported by the housing 2 on the side of a second end 6 thereof. The lever 12 serves to lock (engage with) the free end of the cover member 8. The housing 2 is constituted by a rectangular frame body, that is, an outer housing 3, and an inner housing 120 (see FIG. 4 and FIG. 5) to be described later.

Reference numeral 200 in FIG. 1 denotes an LGA package which is placed on top of the housing 2 and located within the opening 68 of the cover member 8. Referring to FIG. 1, the LGA package 200 is pressed against the upper surface of the housing 2 by the cover member 8 and thereby electrically connected to electric contacts (not shown) of the housing 2. The lever 12 is secured in position by an interlocking protrusion (interlocking portion) 14 of the reinforcing plate 10.

As shown in FIG. 2, the reinforcing plate 10 is a rectangular plate which includes a large rectangular opening 16 at the center thereof. The reinforcing plate 10 is provided on the bottom surface 11 (FIG. 3B) of an outer housing 3 so as to extend substantially along the perimeter of the housing 2 or outer housing 3. In FIG. 2, reference numeral 128 denotes cavities formed within the inner housing 120 for the purpose of accommodating electric contacts (not shown).

In the following, a detailed description will be given regarding the outer housing 3 constituting the housing 2 with reference to FIGS. 3A and 3B. FIGS. 3A and 3B respectively illustrate a perspective view from above and a perspective view from below of the outer housing 3. The outer housing 3 is shaped in the form of a rectangular frame having a centrally disposed rectangular opening 22, and a pair of spaced apart cylindrical shafts 26 is formed at the first end 4 thereof. The cover member 8 mentioned above is pivotally mounted to the cylindrical shafts 26. Each shaft 26 has a flat notch or receiving seat 24 in its top portion.

Gaps 28 vertically extending through the outer housing 3 are formed at portions between the respective shafts 26 and the opening 22, one for each portion. While details are described below, these gaps 28 are provided for attaching the cover member 8. A pair of generally rectangular convex surfaces 30 separated from one another is also formed between the pair of shafts 26. A recess, that is, a receiving seat 32 which is open upward and outward is formed in each convex surface 30. These receiving seats 24 and 32 are at the same height and aligned in the direction they are arranged. At the bottom portion of each of the receiving seats 32, a rectangular block 34 having a thickness of the outer housing 3 is formed.

Vertically extending hollows 36 and 38 are formed on both sides closer to the second end 6 of the outer housing 3. The hollow 36 is formed deeper, while the hollow 38 is formed shallower. A rectangular opening 40 is formed between the hollows 36 and 38 for accommodating therein a locking portion 15 of the lever 12 (FIG. 1). A U-shaped groove 44, which extends parallel to a rear wall 42 and is open downward, is formed so as to communicate the opening 40 and the hollows 36 and 38. The lever 12 is disposed within this U-shaped groove 44.

Sidewalls 46 and 48 extend between the first end 4 and the second end 6. Protruding walls 47 and 49 are formed along these sidewalls 46 and 48, respectively. The protruding wall 47 is continuous, while the protruding wall 49 has a notch 50 formed in the middle thereof. The interlocking protrusion 14 of the reinforcing plate 10 mentioned above is disposed within this notch 50, and the details of the mounting manner will be described later. A groove 52 which is open downward is formed near the U-shaped groove 44 to extend along the rear wall 42, as shown in FIG 3B. Projections 58, 58, 59, 59 which are spaced apart from one another and extend downward are formed in a inner wall 21 of the opening 22 on the first end 4 side and the second end 6 side.

An upward-facing step 23 is formed within the opening 22 of the outer housing 3 along the inner wall 21 of the opening 22. While the details are described later, the inner housing 120 shown in FIG. 4 and FIG. 5 is placed on the step 23. Further, clearance grooves 60 and 62, which extend respectively along the sidewalls 46 and 48 and are open upward, are formed in the vicinity of the opening 22 and inside the sidewalls 46 and 48. These clearance grooves 60, 62 receive sidewalls 70, 70 of the cover member 8, to be described later.

In the following, a description will be given regarding the inner housing 120 with reference to FIG. 4 and FIG. 5. FIG. 4 is a perspective view from above and FIG. 5 is a perspective view from below illustrating the inner housing 120. The inner housing 120 of rectangular shape is molded from insulating material such as resin, and has external dimensions that permits the inner housing 120 to be press-fit inside the inner wall 21 of the opening 22 of the outer housing 3. The inner housing 120 has in its top portion a package receiving part 124, which is defined by an outer peripheral wall 122 and provided for receiving the LGA package 200. The portion of this outer peripheral wall 122 is pressed inside the inner wall 21 mentioned above.

An opening 130 is formed in the bottom surface 126 of this package receiving part 124. A large number of cavities 128 to accommodate electric contacts (not shown) are formed in a matrix pattern on the bottom surface 126 except this opening 130. FIG. 4 shows only a part of the cavities 128. In fact, however, the cavities 128 are formed substantially all over the bottom surface 126 except the opening 130.

As shown in FIG. 5, on the bottom surface of the inner housing 120, an downward-facing step 132 is provided along the four sides or around the entire periphery of the inner housing 120. The downward-facing step 132 abuts against the upward-facing step 23 when the inner housing 120 is positioned within the opening 22 of the outer housing 3 mentioned above. In addition, rectangular holes 134 and recesses 135 disposed along the outer peripheral wall 122 are formed for reducing wall thickness to prevent shrinkage after the inner housing 120 is molded from resin. Reference numeral 136 in FIG. 5 denotes a standoff to maintain the spacing between the printed board (not shown) and the inner housing 120 when the socket 1 is mounted on the printed board.

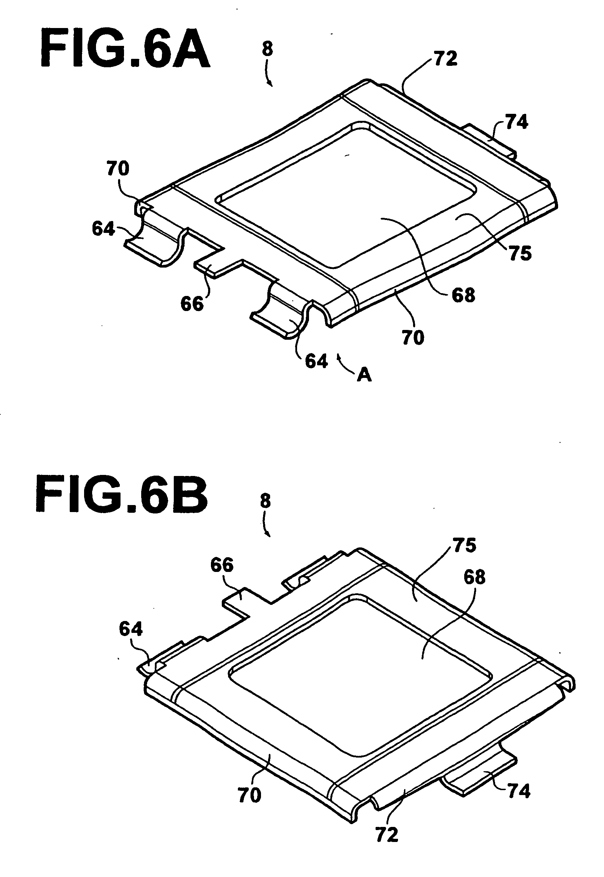

In the following, a description will be given regarding the cover member 8 with reference to FIGS. 6A and 6B. FIGS. 6A and 6B show the cover member 8, wherein FIG. 6A is a perspective view from above and FIG. 6B is a perspective view from above taken along another direction. Herein, for convenience of description, a part located on the first end 4 side of the socket 1, that is, the part indicated by arrow A, is referred to as "front part", and the part located on the second end 6 side (see FIG. 1) is referred to as "rear part". The cover member 8 is formed by stamping and bending a single sheet of metal into a rectangular shape. The cover member 8 has a pair of bearing tongue elements 64 projecting therefrom at its front part. These bearing tongue elements 64 are curved downward and spaced from one another. Further, a holding element 66 is formed midway between the pair of bearing tongue elements 64 so as to project towards the front direction at the level of the cover member 8.

The cover member 8 includes at its center the rectangular opening 68 into which the LGA package 200 (see FIG. 1) is positioned. The opposite edges of the cover member 8 between the front and rear parts are bent down to form side surfaces 70. At the rear part of the cover member 8, there are provided a rear wall 72 formed by bending down the rear edge, and a locking element 74 which projects downward from the middle portion of this rear wall 72 and horizontally extends in an outward direction. This locking element 74 serves to engage with the lever 12. As can be seen from FIGS. 6A and 6B, an upper surface 75 of the cover member 8 is slightly curved downward. This is so that force acts uniformly across the LGA package 200 when the LGA package 200 is pressed against the socket 1 by the cover member 8.

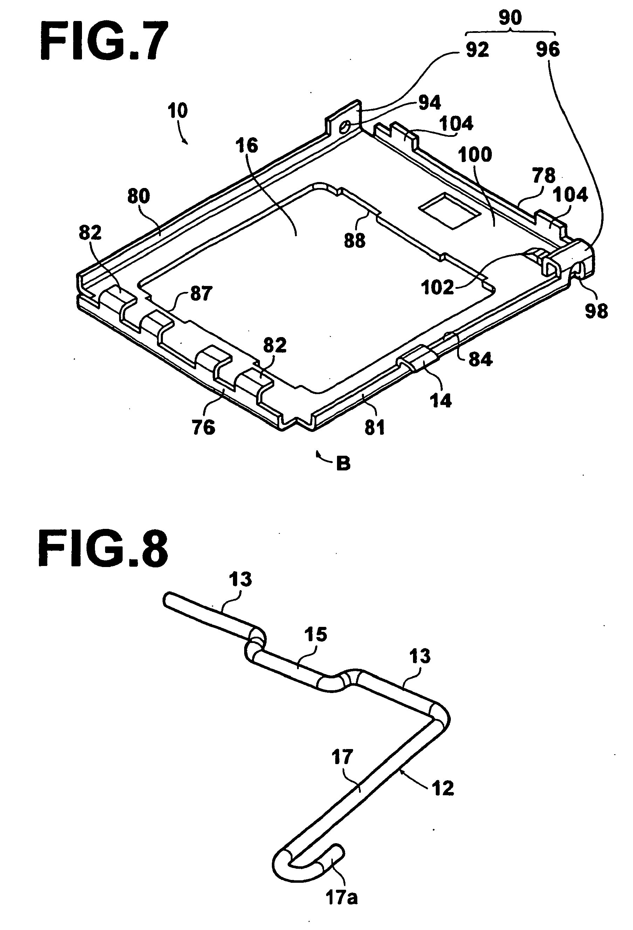

In the following, a description will be given in detail regarding the reinforcing plate 10 to be positioned below the housing 2 with reference to FIG. 7. FIG. 7 is a perspective view from above illustrating a reinforcing plate 10. The reinforcing plate 10 is formed by stamping and bending a single sheet of metal into a rectangular shape. Similar to the cover member 8 mentioned above, for convenience of description, a part located on the first end 4 side of the socket 1, that is, the part indicated by arrow B, is referred to as "front part", and the part located on the second end 6 side (see FIG. 1) is referred to as "rear part". All four side edges of the reinforcing plate 10 are bent up to form a front wall 76, rear wall 78, and sidewalls 80 and 81.

The front wall 76 has four generally L-shaped retaining elements 82 which project upward and are bent inward. The respective retaining elements 82 are spaced apart from one another and disposed so as to correspond with the receiving seats 24 and 32 mentioned above. Each retaining element 82 has a sufficient height to accommodate the edge of the front part of the outer housing 3. The sidewall 80 is formed to extend in the front-rear direction of the reinforcing plate. In an upper edge 84 of a sidewall 81, the interlocking protrusion 14 is formed integrally therewith at a position corresponding to the foregoing notch 50 of the outer housing 3 so that the interlocking protrusion 14 extends laterally towards the exterior in a direction substantially perpendicular to the surface of the sidewall 81. The downward-facing surface of the interlocking protrusion 14 is concavely curved in order to make the lever 12 hard to remove therefrom when the lever is engaged with the interlocking protrusion 14.

As mentioned above, the reinforcing plate 10 has the rectangular opening 16 formed at the center thereof. Notches 87, 88 corresponding to the projections 59, 58 of the outer housing 3 are provided at the front and rear edges of the opening 16. The projections 59, 58 are adapted to mate respectively with the notches 87, 88 such that the relative positional relationship between the reinforcing plate 10 and the cover member 8 is established.

A shaft-supporting portion 90 for pivotally supporting the lever 12 is provided at the rear ends of the sidewalls 80, 81. This shaft-supporting portion 90 is constituted by an upwardly projecting shaft-supporting element 92 formed on the sidewall 80 side, and a shaft-supporting element 96 formed on the sidewall 81 side having an inverted U-shape. The shaft-supporting element 92 has therein an aperture 94, while the shaft-supporting element 96 has therein slots 98 of oblong shape in the vertical direction (only one of which is shown). The aperture 94 and the slots 98 cooperatively serve as a bearing for supporting the lever 12 (see FIG. 1 and FIG. 2).

A tongue element 102 is formed near the shaft-supporting element 96 by cutting a portion of the bottom surface 100 and bending this portion up. The tongue element 102 is adapted to support from underneath a rotary shaft 13 (see FIG. 8) of the lever inserted into the slots 98. The rear wall 78 has projections 104 which are spaced apart from one another and extend upward. These projections are positioned to mate with mounting slits (not shown) formed in the groove 52 of the outer housing 3 mentioned above. When the reinforcing plate 10 is attached to the outer housing 3, the front part of the outer housing 3 is held by the retaining elements 82 disposed at front, and the projections 104 are pressed into the above-mentioned mounting slits (not shown) of the outer housing 3 and held in this position. During insertion of the projections 104, it is preferable that the projections 104 are heated and then pressed into the mounting slits of the outer housing while partially heat-softening the mounting slits 104.

In the following, a detailed description will be given regarding the lever 12 with reference to Figure 8. Figure 8 is a perspective view of the lever 12. The lever 12 is formed by bending a single metallic wire, and comprises rotary shafts 13 which are spaced apart from one another and supported by the shaft-supporting portion 90 of the reinforcing plate 10, a crank portion, that is, a locking portion 15, which is disposed between the rotary shafts 13 and displaced with respect to the rotary shafts 13, and an actuating portion 17 for rotating the rotary shafts 13. The actuating portion 17 is bent at a right angle with respect to the rotary shafts 13 in substantially the same direction as that in which the locking portion 15 is located. Further, the tip region of the actuating portion 17 is turned up into a U-like shape in order to form a U-shaped portion 17a for ease of actuation by a finger.

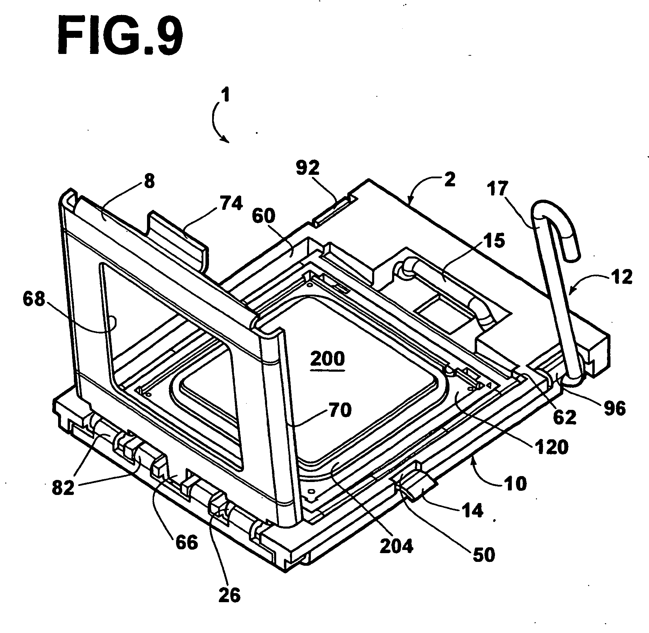

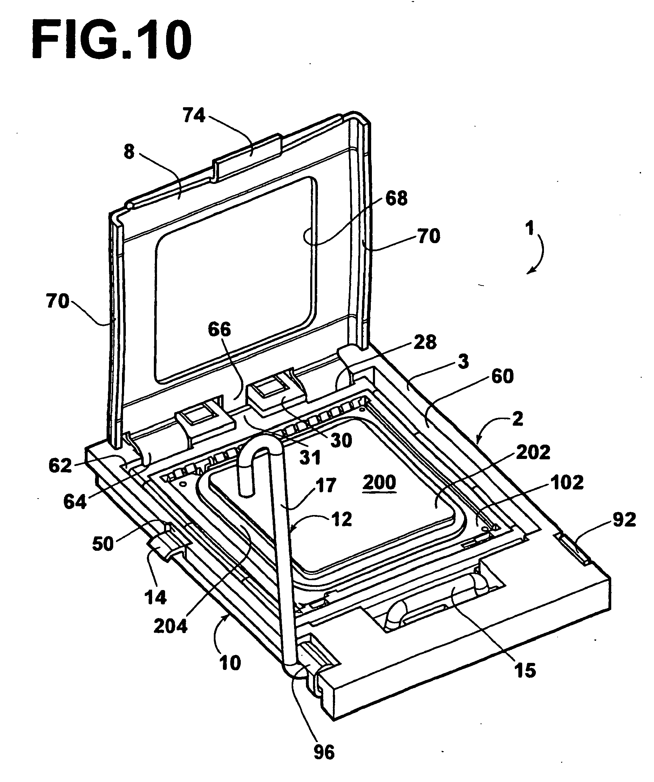

In the following, a description will be given regarding the socket 1 made up of a combination of the above-mentioned components with reference to FIG. 9 and FIG. 10. FIG. 9 is a perspective view from above and FIG. 10 is a perspective view from above taken along another direction, illustrating the socket 1 with the cover member open. Referring to FIGS. 9 and 10, the LGA package 200 is placed on the inner housing 120. Also referring again to FIG. 1, the cover member 8 has the bearing tongue elements 64 inserted into the gap 28 of the outer housing 3, and a holding element 66 disposed between a pair of the convex surfaces 30.

These bearing tongue elements 64 are slidably disposed around the shaft 26 and pivotally support the cover member 8, while the holding element 66 is located between the convex surfaces 30, 30 at a edge of the outer housing 3 and suppresses the movement of the cover member 8 towards the direction in which the cover member 8 falls out from the gap 28. The inner housing 120 is disposed within the opening 22 (see FIGS. 3A and 3B) of the outer housing 3. At this time, the aforementioned clearance grooves 60, 62 are not covered by the inner housing 120. They are adapted to respectively accommodate the sidewalls 70 of the cover member 8 when the cover member 8 is closed.

As clearly shown in FIGS. 9 and 10, the reinforcing plate 10 is disposed on the bottom surface of the housing 2, and the interlocking protrusion 14 of the reinforcing plate 10 is positioned within the notch 50 of the outer housing 3. As can be seen from FIG. 9, the four retaining elements 82 of the reinforcing plate 10 are positioned within the receiving seats 24, 32 of the outer housing 3 and attached to the housing 2. Especially, the retaining elements 82 located within the receiving seats 24 are engaged with the cover member 8 via the shaft 26. Note that the retaining elements 82 also serve as a stopper which limits the rotation range of the cover member.

It is clearly shown that the lever 12 is pivotally supported by the shaft-supporting element 92, 96 of the reinforcing plate 10. The locking portion 15 is in a position where the locking portion 15 is disengaged from the locking element 74 of the cover member 8. That is, the lever 12 is designed to release the engagement with the cover member 8 when the actuating portion 17 of the lever 12 is raised.

The LGA package 200 has a raised portion 202 which is generally complementary with respect to the opening 68, and a flange 204 which extends about the circumference of the raised portion 202. The raised portion 202 is sized such that the raised portion can be received in the opening 68 of the cover member 8. When the cover member 8 is closed and thus placed on the housing 2, the peripheral edge of the opening 68 of the cover member 8 presses the flange 204 of the LGA package 200 towards the inner housing 120.

A description will be given regarding the state during use of the socket 1 constructed in this manner, with reference again to FIG. 1 and FIG. 2. The cover member 8 is locked by the shaft 26 and the locking portion 15 of the lever 12 and in turn presses the LGA package 200. At this time, the force applied to the lever 12 is supported by the shaft-supporting elements 92, 96 of the reinforcing plate 10. As the first end 4 side of the reinforcing plate 10 is engaged with the shaft 26 of the outer housing 3, the housing 2 is held supported as a whole by the rigid metal cover member 8 and the reinforcing plate 10. Accordingly, the downward force caused by the housing 2 pressing the LGA package 200 is supported by the reinforcing plate 10, and there is practically no possibility of deformation of the housing 2.

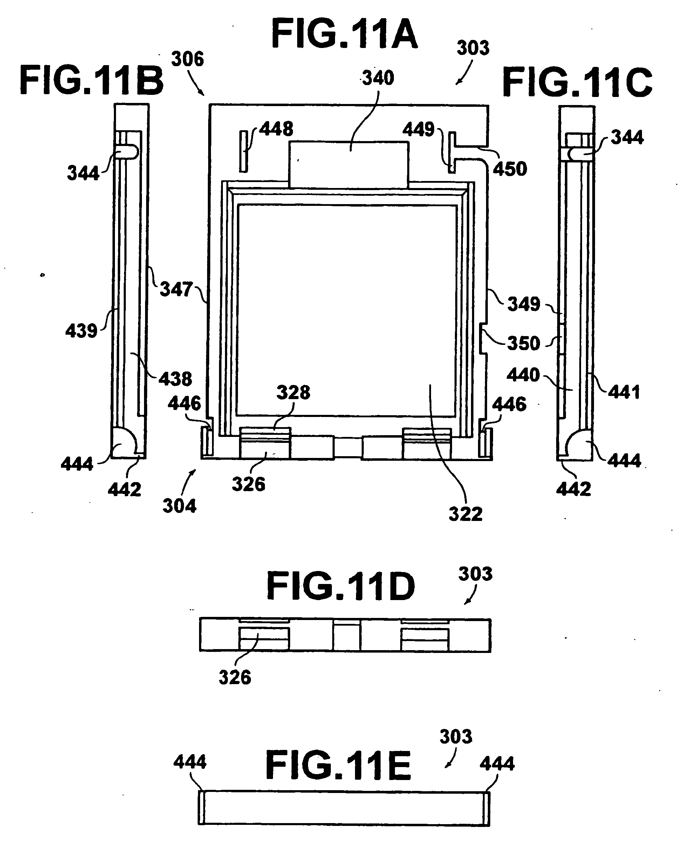

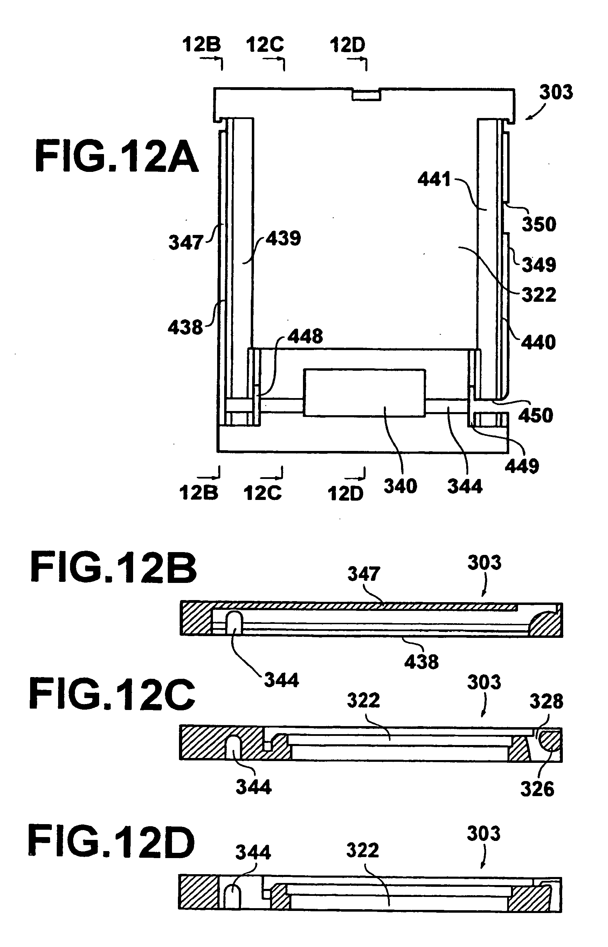

Hereinafter, a second embodiment of the present invention will be explained with reference to FIG. 11 to FIG. 19. The largest difference of the second embodiment from the first embodiment is that the reinforcing plate disposed on the bottom surface of the insulative housing is formed in two members. FIGS. 11A to 11E and FIGS. 12A to 12D illustrate an outer housing. FIG. 11A is a plan view, FIG. 11B is a left side view, FIG. 11C is a right side view, FIG. 11D is a front view, and FIG. 11E is a rear view. FIG. 12A is a bottom view, FIG. 12B is a sectional view taken along line 12B-12B in FIG. 12A, FIG. 12C is a sectional view taken along line 12C-12C in FIG. 12A, and FIG. 12D is a sectional view taken along line 12D-12D in FIG. 12A.

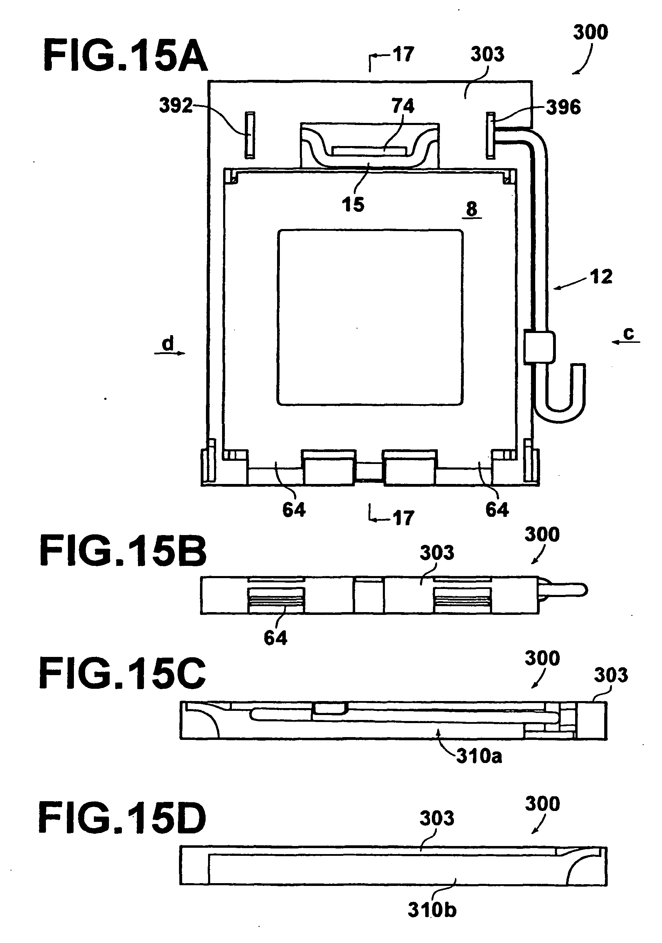

A housing of a socket 300 (see FIG. 15) of the second embodiment is constituted by an outer housing 303, and an inner housing 120 which is the same as that used in the first embodiment. Since the inner housing 120 has been described earlier, description and illustration thereof are omitted. In addition, a cover member and lever used in the second embodiment is same as the cover member 8 and lever 12 used in the first embodiment and no further description will be given. However, if necessary, the same reference numerals as those used in the first embodiment are used for explanation. Thus, with the substantial similarity of the outer housing 303 and the outer housing 3 of the first embodiment in mind, the following description deals mainly with the differences from the outer housing 3.

As shown in FIGS. 11A to 11E and FIGS. 12A to 12D, protruding walls 347 and 349, each of which extends from a first end 304 to a second end 306 of the outer housing 303, are formed at each upper edge of the lateral portions of the outer housing 303, one on each side. Grooves 438 and 440 are respectively formed below and extend along the protruding walls 347, 349. As can be seen from FIG. 12A, these grooves 438 and 440 are respectively in communication with grooves 439 and 441 disposed at the bottom of the outer housing 303.

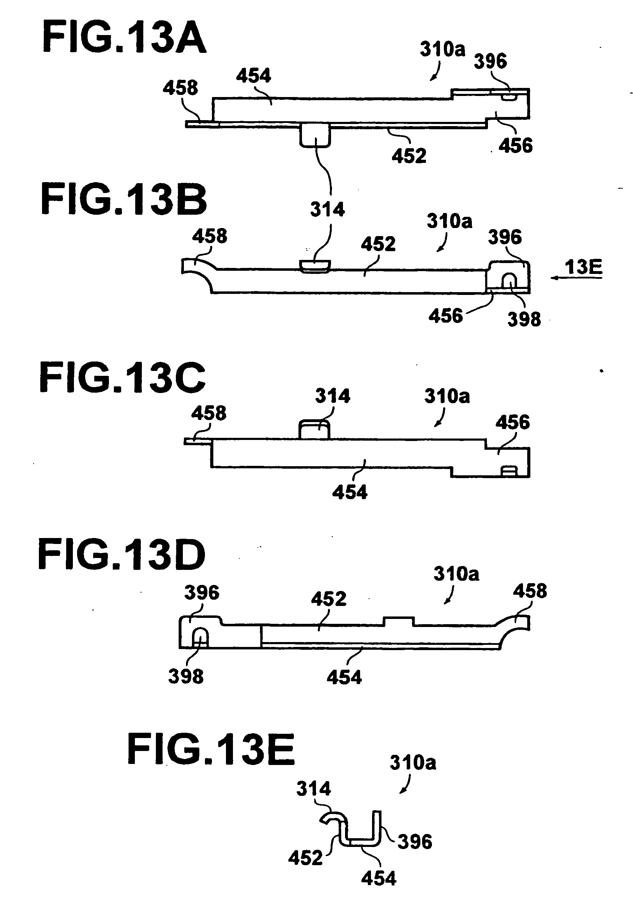

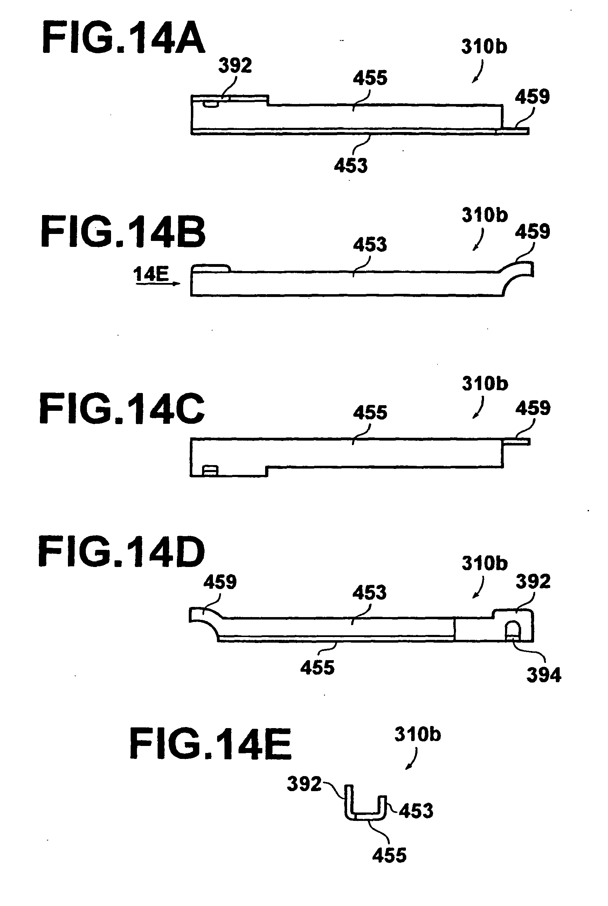

An arcuate interlocking portion 444 having an upward-facing rib 442 is formed in each lateral portion on the first end 304 side. An arcuate interlocking groove 446 is formed within each arcuate interlocking portion 444. A reinforcing plate 310 (see FIG. 13 and FIG. 14) described later is fitted in these grooves 438, 440 and the arcuate interlocking grooves 446, the details of which will be described later. In communication with a U-shaped groove 344 provided in the bottom surface on the second end 306 side of the outer housing 303, slots 448, 449 are formed so as to run in the front-rear direction of the outer housing 303 and vertically extend through the outer housing 303. The slot 449 has a notch 450 open towards the side direction. Here, as for the front-rear direction, the first end 304 side and the second end 306 side in FIG. 11A are respectively taken as "front" and "rear" sides, for convenience.

The outer housing 303 is provided with openings 322 and 340, a shaft 326, a gap 328, and a notch 350, all of which are similar to those in the first embodiment. They have been described in connection with the first embodiment and no further description will be given thereon.

In the following, a description will be given regarding the metallic reinforcing plate used in the socket of the second embodiment with reference to FIGS. 13A to 13E and FIGS. 14A to 14E. This metallic reinforcing plate is formed by two members. First, one metallic reinforcing plate (metallic reinforcing member) 310a disposed within the groove 440 of the outer housing 303 will be described with reference to FIGS. 13A to 13E. FIGS. 13A to 13E illustrate the one reinforcing plate 310a. FIG. 13A is a plan view, FIG. 13B is a front view, FIG. 13C is a bottom view, FIG. 13D is a rear view, and FIG. 13E is a side view taken along arrow 13E in FIG. 13B. Note that "front view", "rear view", etc. in this context are merely used for convenience, and not corresponding to the front view, rear view, etc. of the outer housing 303 shown in FIGS 12A to 12D.

The reinforcing plate 310a is formed by stamping and bending a single sheet of metal into an elongated shape. The reinforcing plate 310a comprises a main wall 452 received in a groove 440, and a bottom wall 454 received in the groove 441. An extension 456 which is deflected to extend in the right hand direction is formed in the bottom wall 454 on the second end 306 side (see FIG. 11A). The extension 456 is provided with a shaft-supporting element 396 to be pressed into and engaged with the slot 449.

The shaft-supporting element 396 has a U-shaped slot 398 for pivotally supporting a lever 12 (see FIG. 15). An arcuate interlocking element 458 to be engaged with the arcuate interlocking groove 446 is formed at the end of the main wall 452 on the side opposite the extension 456. Further, an interlocking protrusion (interlocking portion) 314 is provided in a protruded manner at the upper edge of the main wall 452 so as to mate with the notch 350 of the outer housing 303.

In the following, a description will be given regarding the other metallic reinforcing plate (metallic reinforcing member) 310b to be received in the groove 438 with reference to FIGS. 14A to 14E. FIGS. 14A to 14E illustrate the other reinforcing plate 310b. FIG. 14A is a plan view, FIG. 14B is a front view, FIG. 14C is a bottom view, FIG. 14D is a rear view, and FIG. 14E is a side view taken along arrow 14E in FIG. 14B. Note that "front view", "rear view", etc. in this context are merely used for convenience, and do not correspond to the front view, rear view, etc. of the outer housing 303 shown in FIGS. 12A to 12D.

The reinforcing plate 310b comprises a main wall 453 to be received in the groove 438, a bottom wall 455 to be received in the groove 439, and a shaft-supporting element 392 disposed facing the main wall 453 and projecting from the bottom wall 455 at the end thereof. The upper edge of the shaft-supporting element 392 is made higher than the upper edge of the main wall 452 such that the shaft-supporting element 392 can be pressed into and locked by the slot 448. The shaft-supporting element 392 has a U-shaped slot 394 for pivotally supporting the lever 12. An arcuate interlocking element 459 to be engaged with the arcuate fastening groove 446 is formed at the end of the main wall 452 on the side opposite the shaft-supporting element 392. These reinforcing plates 310a, 310b are both mounted on the underside of the outer housing 303 to support the outer housing 303 from underneath for reinforcement.

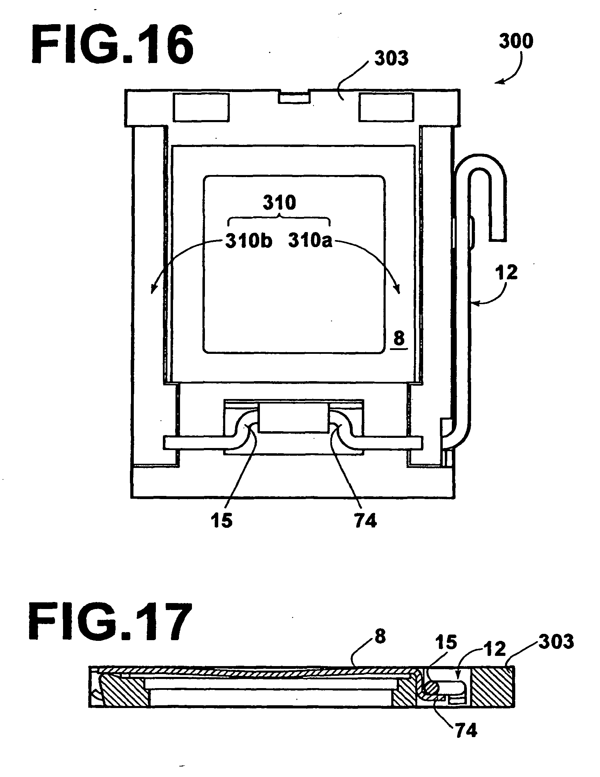

In the following, a description will be given regarding the socket 300 of the second embodiment which is constructed of the aforementioned components with reference to FIGS. 15A to 15D, FIG. 16 and FIG. 17. FIGS. 15A to 15D illustrate the socket 300. FIG. 15A is a plan view, FIG. 15B is a front view, FIG. 15C is a side view taken along arrow 15C of FIG. 15A, and FIG. 15D is a side view taken along arrow 15D of FIG. 15A. FIG. 16 is a bottom view of the socket 300. FIG. 17 is a sectional view of the socket 300 taken along line 17 - 17 in FIG. 15A. In FIGS. 15A-D, FIG. 16 and FIG. 17, an inner housing 120 and an LGA package 200 are omitted.

As best shown in FIGS. 15C and 15D, the unique feature of the second embodiment is that the reinforcing plate formed by two members 310a, 310b is attached to the outer housing 303 from its side to its bottom. That is, it is important that the outer housing 303 is supported from underneath by the reinforcing plate members 310a, 310b. The lever 12 is pivotally supported by the shaft supporting elements 396 and 392 of the reinforcing plate members 310a and 310b. In the same way as in the first embodiment of the invention, a locking element 74 of the cover member 8 is locked by the locking portion 15 of the lever 12, as shown in FIG. 17, when the cover member 8 is closed. The manner that a bearing tongue 64 of the cover member engages with the outer housing 303 is the same as that of the first embodiment, and is not detailed herein.

In the second embodiment, the reinforcing plate 310 formed by two reinforcing plate members 310a, 310b is designed to be mounted on the underside of the outer housing 303 for holding the outer housing 303 between this reinforcing plate 310 and the cover member 8. Accordingly, there is practically no possibility of deformation of the housing 302 including the inner housing 120 when the LGA package 200 is connected thereto. Considering that the force exerted to the housing 302 when connecting the LGA package 200 is substantially supported by two sides extending between the first end 304 and the second end 306, it is conceivable that even the second embodiment can adequately arrest deformation. Further, in accordance with the second embodiment, weight reduction is achieved because such reinforcing plate does not extend entirely about the circumference of the bottom of the housing 302.

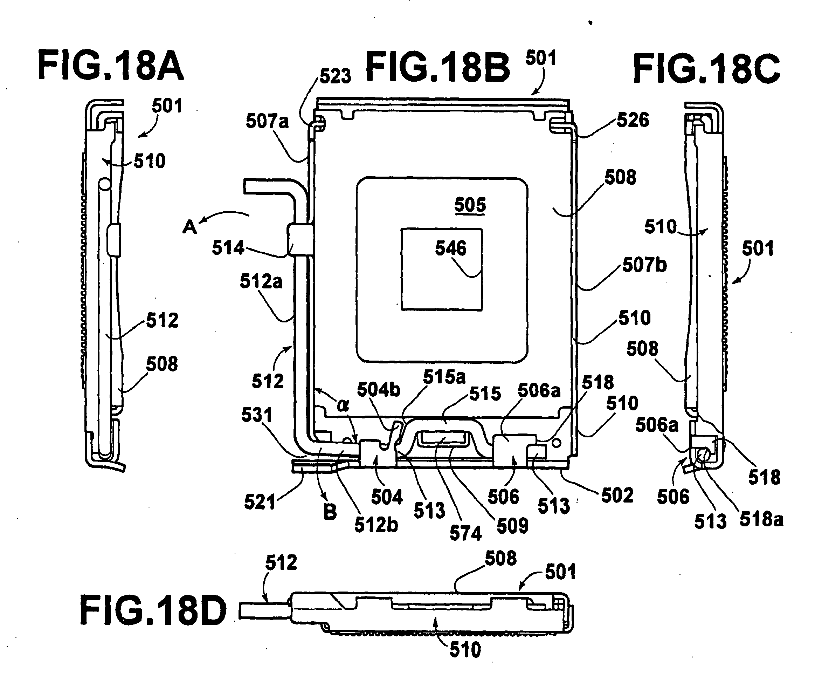

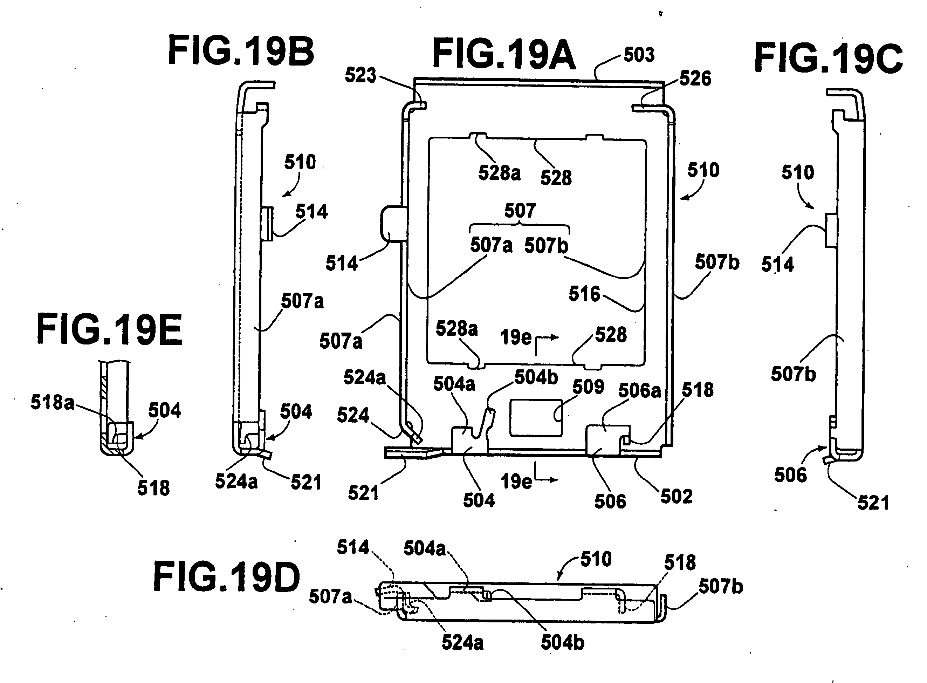

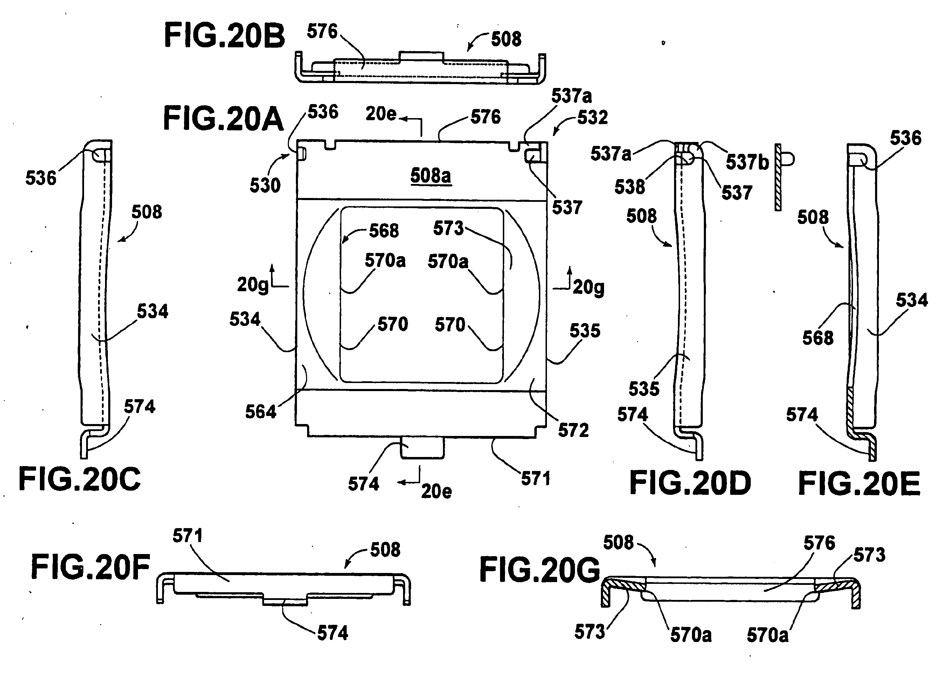

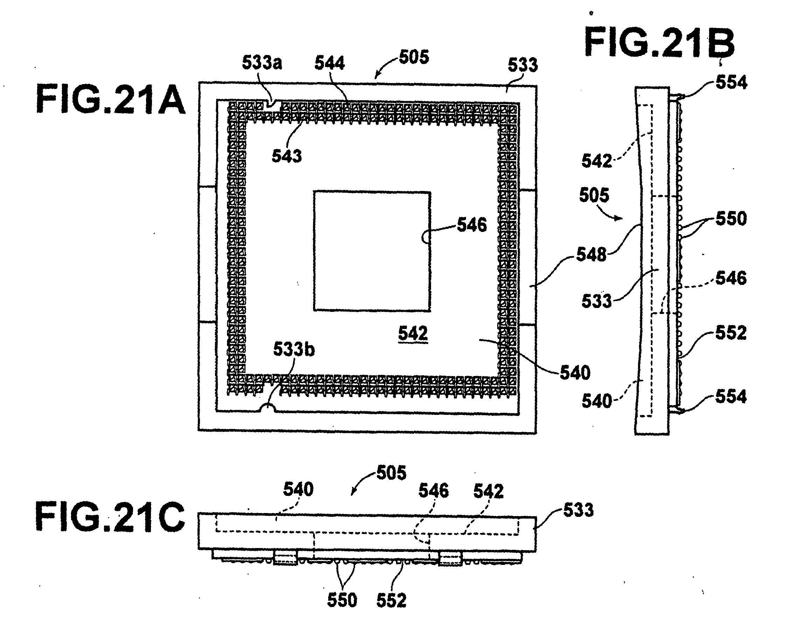

Hereinafter, a third embodiment of the present invention will be explained with reference to FIG. 18A to FIG. 21C. FIGS. 18A to 18D illustrate a socket 501 according to the third embodiment. FIG. 18A is a side view, FIG. 18B is a plan view, FIG. 18C is a partially broken away view seen from another side, and FIG. 18D is a front view. FIGS. 19A to 19E illustrate a metallic reinforcing plate (metallic reinforcement piece) of the socket in FIGS. 18A-18D. FIG. 19A is a plan view, FIG. 19B is a side view seen from one side, FIG. 19C is a view seen from the other side, FIG. 19D is a partial sectional view taken along line 19e-19e in FIG. 19A. FIGS. 20A to 20G illustrate a cover member used for the socket 501. FIG. 20A is a plan view, FIG. 20B is a rear view, FIG. 20C is a view seen from one side, FIG. 20D is a view seen from the other side, FIG. 20E is a sectional view taken along line 20E-20E in FIG. 20A, FIG. 20F is a front view, and FIG. 20G is a sectional view taken along line 20G-20G in FIG. 20A. FIGS. 21A to 21C illustrate an insulative housing (hereinafter, simply referred to as "housing") 505 used for the socket 501. FIG. 21A is a plan view, FIG. 21B is a side view, and FIG. 21C is a front view.

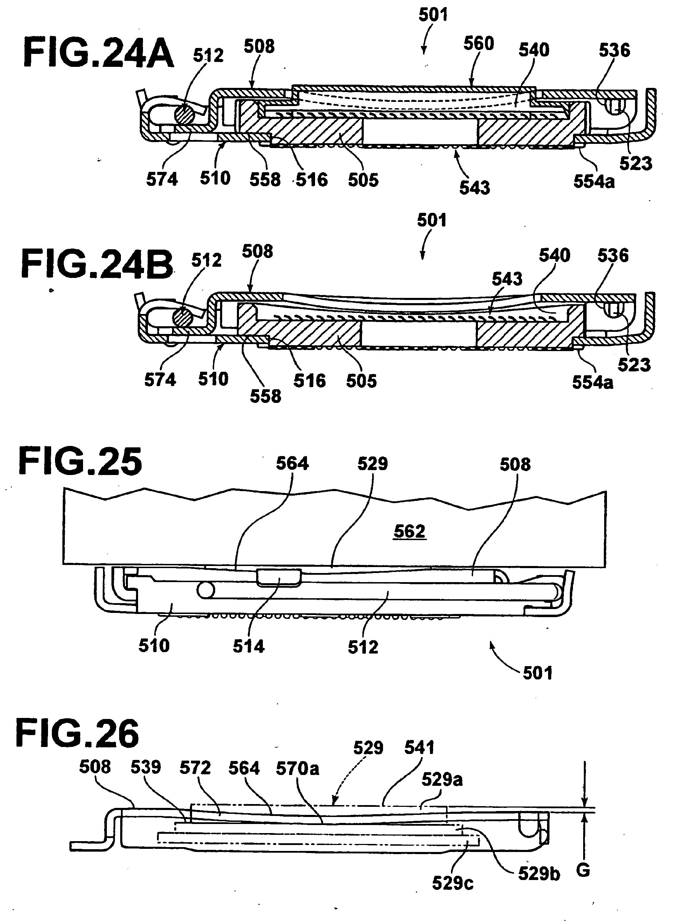

First, a description will be given with reference to FIG. 18A-18D. As shown in FIGS. 18A to 18D, a socket 501 comprises a reinforcing plate 510, a housing 505 accommodated in this reinforcing plate 510, a cover member 508 which is pivotably mounted at a first end of the reinforcing plate 510, and a lever 512 for locking the cover member 508. A cavity 544 (see FIG. 21A) of the housing 505 and an LGA package 529 (see FIG. 26) are omitted from FIGS. 18A-18D for clarity. The lever 512 is pivotally supported on a second end of the reinforcing plate 510, opposite the first end, and adapted to engage with a locking element 574 which is positioned at a free end of the cover member 508 when the housing 505 is closed by the cover member 508.

The socket 501 of the third embodiment is different from the aforementioned first and second embodiments in that the cover member 508 is directly engaged with the reinforcing plate 510 without the intermediary of the insulative housing 505. This avoids undue bending stresses with respect to the insulative housing 505, whereby the possibility of deformation of the insulative housing 505 is reduced. The details of this engagement relationship will be described later. Here, no further description will be given on other structures similar to those of the aforementioned embodiments.

In the following, a description will be given regarding the reinforcing plate 510 in detail with reference also to FIGS. 19A-19D. The reinforcing plate 510 is a generally rectangular plate having therein a rectangular opening 516, and has walls 502, 503 and sidewalls 507 (507a, 507b) around its entire periphery along the four sides. Supporting portions 504 and 506 for pivotally supporting the lever 512 are formed in one piece with the wall 502 so as to project therefrom by bending these supporting portions 504 and 506 inward away from the wall 502. The supporting portion 506 comprises a plate portion 506a bent inward and extending away from the wall 502, and a supporting tongue element 518 (see FIG. 18C), which is bent at the side part near the tip of this plate 506a, for supporting the rotary shaft (rotatably-supported portion) 513 of the lever 512. This supporting tongue element 518 has an arcuate portion 518a which cooperates with the plate portion 506a to support therebetween the rotary shaft 513.

Further, the other supporting portion 504 comprises a plate portion 504a which is bent and extends away from the wall 502 similar to the plate portion 506a. As best shown in FIG. 19A and FIG. 19D, the supporting portion 504 further comprises a pressing tongue element 504b which extends obliquely downward from the plate portion 504a. The pressing tongue element 504b is for preventing a cranked locking portion 515 (see FIG. 18B) of the lever 512 to drop out towards the left hand direction of FIG. 18B. That is, when the locking portion 515 of the lever 512 is likely to drop out leftward of FIG. 18B, the side surface 515a of the locking portion 515 comes into abutment against the pressing tongue element 504b and blocks leftward movement of the locking portion 515. A rectangular opening 509 disposed between both supporting portions 504 and 506 serves as a clearance for the locking element 574 of the cover member 508 when the locking element 574 is locked by the locking portion 515 of the lever 512.

In FIG. 19A, on the left hand of the wall 502, a stop wall 521 is provided along the extended line from the wall 502. The function of the stop wall 521 will be described below with reference to FIG. 18B. Referring to FIGS. 18A to 18D, the cover member 508 is closed and the lever 512 is engaged with an interlocking protrusion (interlocking portion) 514 of the reinforcing plate 510 of the lever 512. It is necessary, however, to release the engagement between the locking portion 515 and locking element 574 and open the cover member 508 when attaching the LGA package 529 or removing the attached LGA package 529. At this time, the lever 512 is released from the engagement with the interlocking protrusion 514 by moving an actuating portion 512a of the lever 512 in the direction indicated by arrow A. This enables the lever 512 to rotate around the rotary shaft 513.

Moving the actuating portion 512a causes the displacement of the shaft 512b from the supporting portion 504 to the actuating portion 512a, in the direction indicated by arrow B. Therefore, it is essential that a space 531 is provided on a side of this shaft 512b opposite the actuating portion 512a. Without this space 531, the shaft 512b is obstructed from moving in the direction indicated by arrow B by the stop wall 521. Thus, a larger force is required to actuate the actuating portion 512a, which reduces the operability of the lever 512.

Accordingly, in this third embodiment, the actuating portion 512a is disposed to form an obtuse angle α with the shaft 512b in order to provide the space 531. The angle α is preferably within the range from 91° to 95°, and more preferably within the range from 92° to 93°. At this time, the angle formed between the rotatably-supported portion 513 and the actuating portion 512a is a right angle. That is, only the shaft 512b is formed in a slightly inclined orientation relative to the rotatably-supported portion 513. The aforementioned stop wall 521 is for maintaining the lever 512 in an open condition.

A description will be given with reference again to FIG. 19A-19D. The sidewall 507a edge at the first end is bent inward at a right angle to form a rotary shaft 523 of the cover member 508. At the second end of the sidewall 507a, a shaft-supporting element 524 is provided in a form bent obliquely inward. This shaft-supporting element 524 has an upward-facing arcuate portion 524a for supporting the shaft 512b of the lever 512. The rotary shaft 513 is rotatably supported by the aforementioned plate portion 504a and shaft-supporting element 524, and the plate portion 506a and arcuate portion 518a. This allows the lever 512 to be held rotatably with respect to the reinforcing plate 510 via the supporting portions 504, 506.

At the first end of the sidewall 507b, a rotary shaft 526 is also formed corresponding with the rotary axis 523. Owing to these rotary shafts 523 and 526, the cover plate 508 is pivotally supported by the reinforcing plate 510, the details of which will be described later.

Four notches (engagement portions) 528a are formed in the opposite end edges 528 of the aforementioned opening 516 of the reinforcing plate 510. These notches 528a are provided as the portions to which the housing 505 is mounted by the use of a thermal pressing technique. The details of mounting will be described later.

In the following, a description will be given regarding the cover plate 508 in more detail with reference also to FIGS. 20A-20G. The cover member 508 is formed by stamping and bending a sheet of metal. It has a rectangular shape and includes a rectangular opening 568. A locking element 574 is formed at a middle of a wall 571 of the cover member 508, and shaft-engaging portions 530, 532 are formed respectively on side surfaces 534, 535, in the vicinity of a wall 576 opposite to the wall 571. The shaft-engaging portion 530 has a U-shaped shaft-receiving aperture 536 formed by stamping and bending on the first side of the sidewall 534. The shaft-engaging portion 532 has a U-shaped notch 538 formed on the first side of the sidewall 535, and a shaft-receiving aperture 537 formed by a principal plane 508a of the cover member 508. The aforementioned rotary shafts 523 and 526 respectively inserted into such shaft-receiving apertures 536 and 357, which allows the cover member 508 to be pivotally supported by the reinforcing plate 510.

The shaft-receiving aperture 536 is a closed aperture, while the shaft-receiving aperture 537 is constituted by a tongue element 537a extending from the principal plane 508a, and another tongue element 537b extending from the sidewall 535. The cover member 508 is mounted by first engaging the shaft-engaging portion 530 with the rotary shaft 523 of the reinforcing plate 510, and then engaging the shaft-engaging portion 532 with the rotary shaft 526. The tongue element 537a is slightly inclined toward the tongue element 537b to reduce the gap between both tongue elements 537a and 537b, and thus the engagement of the shaft-engaging portion 532 with the rotary shaft 526 will not released.

As can be seen from FIGS. 20A-20G, a principal surface 508a of the cover member 508 is slightly curved. That is, as best shown in FIG. 20A, a part of the principal surface508a of the cover member 508 extending from the external edges of the cover member 508 to the opposed end edges 570, 570 of the opening 568 is formed so as to be convex towards the side further to the person viewing the drawing. The curved surfaces of an area 572 and area 573 have curvatures that differ from one another. That is, the area 572 has a smaller curvature, while the area 573 has a larger curvature. For example, the radius of curvature at the area 572 having the smaller curvature is set to be 788 mm, while the radius of curvature at the area 573 having the larger curvature is set to be 213 mm. The middle portion of each end edge 570 is the most protruded portion. The LGA package 529 is pressed through these portions, that is, pressure-applying points 570a, 570a.

In the following, a description will be given regarding the manner in which the LGA package 529 is pressed by the cover member 508 with reference also to FIG. 26. FIG. 26 is a transparent side view of an essential part of the LGA package socket illustrating the state that the cover member 508 of the socket 501 presses the LGA package 529, which is shown by broken lines. The LGA package 529 has a three-layer construction. Specifically, the LGA package 529 is constituted by a heat-radiating portion 529a, a load-bearing portion 529b disposed directly underneath thereof, and a substrate 529c disposed directly underneath thereof. The load-bearing portion 529b has a larger area than that of the heat-radiating portion 529a, and is provided with upward-facing steps 539. The aforementioned pressure-applying points 570a abut the steps 539, one against each step, and, in turn, press the load-bearing portion 529b downward.

The pressure-applying points 570a are also a power point to which a load from the LGA package 529 is imposed. Therefore, the pressure-applying points 570a are most likely to undergo vertical displacement, while the displacement magnitude of the area 572 disposed apart from the pressure-applying points 570a is small. Thus, the deformation at the area 572 controls the deformation of the cover member 508, such that the pressure-applying points 570a positively hold the LGA package 529 in a pressed state. At this time, even if the cover member 508 deforms under pressure, a gap G is formed between the cover member 508 and the upper surface 541 of the LGA package 529. Accordingly, the heat sink 562 described later is mounted to the upper surface of the heat-radiation portion of the LGA package, the heat sink 562 can not be biased in a direction where the heat sink 562 is released from the LGA package 529, that is, in an upward direction.

Next, the housing 505 will be described in further detail with reference to FIGS. 21A to 21C. The housing 505 is molded from insulating material in a rectangular shape, and has a package-receiving portion 540 surrounded by an outer peripheral wall 533. A large number of cavities 544 to accommodate contacts are formed in a matrix pattern on the bottom surface 542 of the package-receiving portion 540. FIG. 21A shows only a portion of the cavities 544; the remaining cavities are omitted. In fact, however, the cavities 544 are formed substantially all over the bottom surface 541 except the opening 546. Electric contacts 543 are disposed within the cavities 544.

Two types of protrusions 533a and 533b, which serve as keys when receiving the LGA package 529, are disposed inside the peripheral wall 533. Recesses 548 are formed on the opposite sides of the peripheral wall 533, one on each side. These recesses 548 are shaped to correspond to the curve of the cover member 508. These recesses 548 serve as a clearance for preventing interference of the housing 505 with the curved surface of the cover member 508 when the cover member 508 is closed and thus placed on the housing 505. Soldering balls 550 connected to the large number of electric contacts 543 for connecting to an unshown circuit board project from the lower surface 552 of the housing 505. As is best seen in FIG. 21B, protrusions (swaging portion) 554 are integrally formed with the housing 505 and project from the lower surface 552. These protrusions 554 are respectively engaged with the aforementioned notches 528a, and then subjected to heat pressing. The details of this operation will be described below.

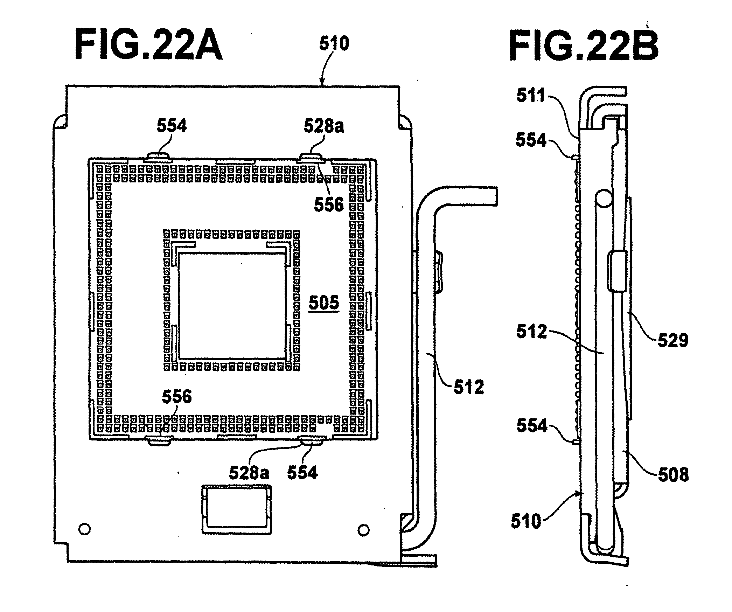

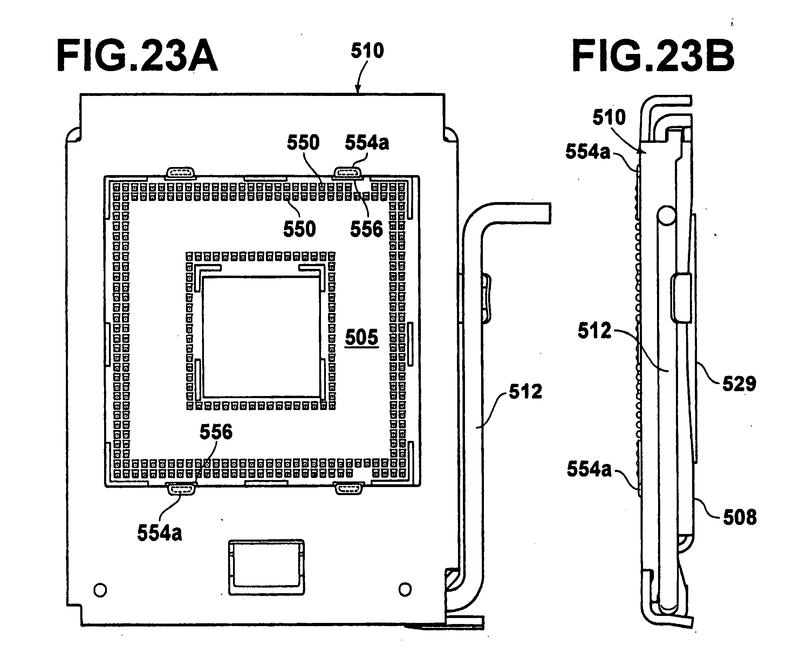

In the following, a detailed description will be given regarding the mounting relationship between the housing 505 and the reinforcing plate 510 with reference to FIGS. 22A-22B and FIGS. 23A-23B. FIGS. 22A and 22B illustrate the housing 505 placed on but not yet fixed to the reinforcing plate 510. FIG. 22A is a bottom view, and FIG. 22B is a side view. FIGS. 23A and 23B illustrate the housing 505 completely secured to the reinforcing plate 510. FIG. 23A is a bottom view, and FIG. 23B is a side view.

First, when the housing 505 is placed on the reinforcing plate 510 as shown in FIG. 22, the aforementioned four protrusions 554 come into engagement with the corresponding notches 528a of the reinforcing plate 510. That is, the protrusions 554 are positioned within the notches 528a, respectively. At this time, as clearly illustrated in FIG. 22, the protrusions 554 protrude from the lower surface 511 of the reinforcing plate 510. In FIG. 22A, recesses, indicated by reference numeral 556, are formed in the housing 505 adjacent the protrusions 554. The operation of the recesses 556 will be described later.

Such projecting protrusions 554 are integrally molded from resin with the housing 505, and therefore heat pressing of the protrusions 554 from the lower surface 511 of the reinforcing plate 510 results in a shape shown in FIG. 23A. That is, referring to FIG. 23A, the protrusions 554 subjected to heat pressing are welded and pressed, and thus flattened portions 554a each of which extends around the corresponding notch 528a are formed. As the flattened portions 554a are cooled, they are solidified to fix the housing 505 to the reinforcing plate 510. When the protrusions 554 are welded, the molten material thereof flows into the aforementioned recesses 556. This prevents the molten material from flowing to the soldering balls 550 near the protrusions 554, and, in turn, prevents the molten material from adhering to the soldering balls 550. Consequently, the electrical connections are not adversely affected thereby.

In the following, a description will be given regarding the construction of the assembled socket 501 with reference to FIGS. 24A and 24B. FIGS. 24A and 24B illustrate an essential part of the socket 501. FIG. 24A is a sectional view with a suction cap 560 attached, and FIG. 24B is a sectional view with a suction cap removed and the LGA package 529 not yet attached. FIGS. 24A and 24B clearly show that the housing 505 is positioned within the opening 516 of the reinforcing plate 510. It is also clearly shown that the reinforcing plate 510 is fixed by the aforementioned flattened portions 554a and a step 558 of the housing 505.

As is shown in FIG. 24A, the suction cap 560 is disposed within the package-receiving portion 540 of the housing 505, and fixed by the cover member 508. In this condition, the suction cap 560 is suctioned by a suction unit not shown, and the socket 501 is carried to a predetermined circuit board (not shown) and mounted thereon. Thereafter, the suction cap 560 is removed as shown in FIG. 24B. Then the LGA package 529 is attached to the package-receiving portion 540. As clearly shown in FIGS. 24A and 24B, the cover member 508 is rotatably supported by the rotary shaft 523 (526) and the shaft-bearing hole 536 (537). It is also clearly shown therein that the electric contacts are arranged.

In the following, a description will be given regarding the case that the heat sink is mounted with reference to FIG 25. FIG. 25 is a side view of an assembly with the heat sink 562 mounted on the socket 501. After the LGA package 529 is attached to the socket 501, the heat sink 562 is mounted on a board on which the socket 501 is placed on a casing (not shown) separately from the socket 501. At this time, a flat upper surface of the LGA package 529 and a flat lower surface of the heat sink 562 become in surface contact with each other, whereby the heat of the LGA package 529 is transferred to and dissipated via the heat sink 562. Since the upper surface 564 of the cover member 508 is curved downward, a gap is formed between the upper surface 564 of the attached cover member 508 and the heat sink 562 as described above in connection with FIG. 26, whereby the heat sink 562 will not biased upward by the cover member 508.

Although the present invention has been described in detail, it goes without saying that the present invention is not limited to the embodiments described above but is susceptible to various changes and modifications without departing from the scope of the invention. For example, in the first and second embodiments, the outer housing 3, 303 and the inner housing 120 are constructed separately from each other, they may be molded in one piece of resin.

The cover member and the reinforcing member need not necessarily be engaged via the housing, but may be directly engaged with one another. As an example of direct engagement, it is possible that the cover member is pivotally supported by the reinforcing member. In this case, the cover member may have a rotary shaft and the reinforcing member may have a rotary-shaft bearing, or vice versa.

As an alternative example of direct engagement of the cover member with the reinforcing member, it is also possible that each of the cover member and the reinforcing member has an aperture for a rotary shaft, and that the cover member is pivotally mounted to the reinforcing member by a metallic shaft member which is separate from the reinforcing member.

While the housing 505 is attached to the reinforcing plate 510 by subjecting the protrusions 554 of the housing 505 to thermal pressing in the third embodiment, such attachment may be accomplished by any swaging scheme which can form an appropriate engagement relationship.

References in the specification to "end" should be interpreted as meaning "end region".

## Claims

1. A land grid array (LGA) package socket (1), comprising:
a rectangular insulative housing (3, 120) having large number of cavities (128) each of which accommodates an electric contact; a cover member (8) pivotally mounted on a first end (4) of the insulative housing (3, 120); and a lever (12) pivotally mounted on a second end (6), opposite the first end (4) of the insulative housing (3, 120), wherein when the cover member (8) is closed, and LGA package (200) placed on the insulative housing (3, 120) is pressed against the electric contacts to form electrical connections and a free end of the closed cover member (8) is locked by the lever (12),
**characterised in that** the lever (12) is pivotally supported on the second end (6), a metallic reinforcing member (10) extending between the first end (4) and the second end (6) is provided on an underside of the insulative housing (3, 120) and the LGA package (200) and the insulative housing (3, 120) are held in close association with one another between the metallic reinforcing member (10) and the cover member (8).

2. The LGA package socket (1) according to claim 1, wherein the metallic reinforcing member (10) comprises an interlocking portion (14) formed integrally therewith, the interlocking portion (14) serving to lock the lever (12) with the lever (12) and the cover member (8) in an engaged state.

3. The LGA package socket (1) according to claim 1 or claim 2 wherein the metallic reinforcing member (10) is a one-piece component which extends along an entire periphery of the insulative housing (3, 120).

4. The LGA package socket (300) according to claim 1 or claim 2, wherein the metallic reinforcing member is formed in two members (310a, 310b) which are attached to the insulative housing (303) along two sides thereof each of which extends between the first end (304) and the second end (306).

5. The LGA package socket (501) according to any one of claims 1 to 4 wherein the cover member (508) is pivotally supported (523, 526) by the metallic reinforcing member (510) at the first end of the insulative housing (505).

6. The LGA package socket according to claim 5 wherein each of the cover member and the reinforcing member has an aperture for a rotary shaft, and the cover member is pivotally mounted to the reinforcing member by a metallic shaft member which is separate from the metallic reinforcing member.

7. A land grid array (LGA) package socket (501), comprising: a rectangular housing (505) having a large number of cavities (544) each of which comprises an electrical contact (543); a metallic reinforcing member (510) for accommodating the insulative housing (505); a cover member (508) pivotally mounted on a first end of the metallic reinforcing member (510); and a lever (512) pivotally mounted on the second end, opposite the first end of the metallic reinforcing member (510),
wherein when the cover member (508) is closed, the insulative housing (505) and the LGA package (529) placed in the insulative housing (505) are held between the metallic reinforcing member (510) and the cover member (508) while a free end of the enclosed cover member (508) is locked by the lever (512), with the result that the LGA package (529) is electrically connected with the electric contacts (543).

8. The LGA package socket (501) according to claim 7 wherein the lever (512) comprises a locking portion (515) for locking a free end of the cover member (508), a rotatably-supported portion (513) which is rotatably supported by the metallic reinforcing member (510) on both sides of the locking portion (515), and an actuating portion (512a) bent at a predetermined angle away from the rotatably-supported portion so that the actuating portion (512a) can be engaged with an interlocking protrusion (514) of the metallic reinforcing member (510); and
wherein the shaft from the rotatably supported portion (513) on the actuating portion side to the actuating portion (512a) has a length which is sufficient to allow the displacement of the shaft associated with disengaging the actuating portion (512a) from the interlocking protrusion (514), and a space (531) for accommodating the displacement is provided at a position located on the side opposite at least the actuating portion (512a) of the shaft (512).

9. The LGA package socket (501) according to claim 8, wherein an angle between the actuating portion (512a) and the shaft-bearing portion (513) is set to a right angle and an angle between the shaft (512b) and the actuating portion (512a) is set to an obtuse angle α, with the result that the space (531) is provided at a position located on the side opposite to the actuating portion (512a) of the shaft (512).

10. The LGA package socket (501) according to any one of claims 7 to 9 wherein the insulative housing (505) has a plurality of swaging portions (554), the metallic reinforcing member (510) has an engaging portion (528a) adapted to be engaged with the swaging portion (554), and the insulative housing (505) is fixed to the metallic reinforcing member (510) by swaging the swaging portions (554).

11. The LGA package socket (501) according to any one of claims 7 to 10 wherein the cover member (508) comprises: an opening (516) for exposing a part of the LGA package (529); a curved surface (572, 573) which extends from the external edges (534, 535) of the cover member (508) to the opposed end edges (570) of the opening (568) and is formed to be convex towards the LGA package side; and a pressure-applying point (570a) which is disposed at the most protruded portion of each curved surface (572, 573) and adapted to press the LGA package (529) when the cover member (508) is closed.

12. The LGA package socket (501) according to claim 11 wherein the curved surface (572, 573) has progressively increasing curvatures, and has the largest radius of curvature at the pressure applying point (570a).

## Patentansprüche

1. Steggittermatrix- (LGA - land grid array) Bausteinbuchse (1), die Folgendes umfasst:
ein rechteckiges isolierendes Gehäuse (3, 120), das eine große Zahl von Hohlräumen (128) hat, deren jeder einen elektrischen Kontakt aufnimmt, ein Abdeckelement (8), das schwenkbar an einem ersten Ende (4) des isolierenden Gehäuses (3, 120) angebracht ist, und einen Hebel (12), der schwenkbar an einem zweiten Ende (6), gegenüber dem ersten Ende (4) des isolierenden Gehäuses (3, 120), angebracht ist, wobei, wenn das Abdeckelement (8) geschlossen wird, ein auf dem isolierenden Gehäuse (3, 120) angeordneter LGA-Baustein (200) gegen die elektrischen Kontakte gepresst wird, um elektrische Verbindungen herzustellen, und ein freies Ende des geschlossenen Abdeckelements (8) durch den Hebel (12) arretiert wird,
**dadurch gekennzeichnet, dass** der Hebel (12) schwenkbar am zweiten Ende (6) getragen wird, ein metallisches Verstärkungselement (10), das sich zwischen dem ersten Ende (4) und dem zweiten Ende (6) erstreckt, auf einer Unterseite des isolierenden Gehäuses (3, 120) bereitgestellt wird und der LGA-Baustein (200) und das isolierende Gehäuse (3, 120) in einer engen Zuordnung zueinander zwischen dem metallischen Verstärkungselement (10) und dem Abdeckelement (8) gehalten werden.

2. LGA-Bausteinbuchse (1) nach Anspruch 1, wobei das metallische Verstärkungselement (10) einen integral mit demselben geformten Verriegelungsabschnitt (14) umfasst, wobei der Verriegelungsabschnitt (14) dazu dient, den Hebel (12) zu arretieren, wobei sich der Hebel (12) und das Abdeckelement (8) in einem Eingriffszustand befinden.

3. LGA-Bausteinbuchse (1) nach Anspruch 1 oder Anspruch 2, wobei das metallische Verstärkungselement (10) ein einteiliges Bauteil ist, das sich längs eines gesamten Umfangs des isolierenden Gehäuses (3, 120) erstreckt.

4. LGA-Bausteinbuchse (300) nach Anspruch 1 oder Anspruch 2, wobei das metallische Verstärkungselement in zwei Elementen (310a, 310b) geformt ist, die am isolierenden Gehäuse (303) längs zweier Seiten desselben befestigt sind, deren jedes sich zwischen dem ersten Ende (304) und dem zweiten Ende (306) erstreckt.

5. LGA-Bausteinbuchse (501) nach einem der Ansprüche 1 bis 4, wobei das Abdeckelement (508) am ersten Ende des isolierenden Gehäuses (505) schwenkbar (523, 526) durch das metallische Verstärkungselement (510) getragen wird.

6. LGA-Bausteinbuchse nach Anspruch 5, wobei sowohl das Abdeckelement als auch das Verstärkungselement eine Öffnung für eine sich drehende Welle hat und das Abdeckelement durch ein metallisches Wellenelement, das vom metallischen Verstärkungselement gesondert ist, schwenkbar am Verstärkungselement angebracht ist.

7. Steggittermatrix- (LGA) Bausteinbuchse (501), die Folgendes umfasst:
ein rechteckiges Gehäuse (505), das eine große Zahl von Hohlräumen (544) hat, deren jeder einen elektrischen Kontakt (543) umfasst, ein metallisches Verstärkungselement (510) zum Aufnehmen des isolierenden Gehäuses (505), ein Abdeckelement (508), das schwenkbar an einem ersten Ende des metallischen Verstärkungselements (510) angebracht ist, und einen Hebel (512), der schwenkbar an dem zweiten Ende, gegenüber dem ersten Ende des metallischen Verstärkungselements (510), angebracht ist,
wobei, wenn das Abdeckelement (508) geschlossen wird, das isolierende Gehäuse (505) und der im isolierenden Gehäuse (505) angeordnete LGA-Baustein (529) zwischen dem metallischen Verstärkungselement (510) und dem Abdeckelement (508) gehalten werden, während ein freies Ende des eingeschlossenen Abdeckelements (508) durch den Hebel (512) arretiert wird, mit dem Ergebnis, dass der LGA-Baustein (529) elektrisch mit den elektrischen Kontakten (543) verbunden wird.

8. LGA-Bausteinbuchse (501) nach Anspruch 7, wobei der Hebel (512) einen Arretierabschnitt (515) zum Arretieren eines freien Endes des Abdeckelements (508), einen drehbar getragenen Abschnitt (513), der auf beiden Seiten des Arretierabschnitts (515) drehbar durch das metallische Verstärkungselement (510) getragen wird, und einen Betätigungsabschnitt (512a), der in einem vorbestimmten Winkel vom drehbar getragenen Abschnitt weg gebogen ist, umfasst, so dass der Betätigungsabschnitt (512a) mit einem Verriegelungsvorsprung (514) des metallischen Verstärkungselements (510) in Eingriff gebracht werden kann, und
wobei die Welle von dem drehbar getragenen Abschnitt (513) auf der Seite des Betätigungsabschnitts bis zu dem Betätigungsabschnitt (512a) eine Länge hat, die ausreicht, um das Verschieben der Welle zu ermöglichen, das mit dem Ausrücken des Betätigungsabschnitts (512a) aus dem Verriegelungsvorsprung (514) verbunden ist, und ein Raum (531) zum Aufnehmen der Verschiebung an einer Position bereitgestellt wird, die auf der Seite angeordnet ist, die wenigstens dem Betätigungsabschnitt (512a) der Welle (512) gegenüberliegt.

9. LGA-Bausteinbuchse (501) nach Anspruch 8, wobei ein Winkel zwischen dem Betätigungsabschnitt (512a) und dem Wellenlagerabschnitt (513) auf einen rechten Winkel festgesetzt ist und ein Winkel zwischen der Welle (512b) und dem Betätigungsabschnitt (512a) auf einen stumpfen Winkel α festgesetzt ist, mit dem Ergebnis, dass der Raum (531) an einer Position bereitgestellt wird, die auf der Seite angeordnet ist, die dem Betätigungsabschnitt (512a) der Welle (512) gegenüberliegt.

10. LGA-Bausteinbuchse (501) nach einem der Ansprüche 7 bis 9, wobei das isolierende Gehäuse (505) mehrere Stauchabschnitte (554) hat, das metallische Verstärkungselement (510) einen Eingriffsabschnitt (528a) hat, dafür eingerichtet, mit dem Stauchabschnitt (554) in Eingriff gebracht zu werden, und das isolierende Gehäuse (505) durch Stauchen der Stauchabschnitte (554) an dem metallischen Verstärkungselement (510) befestigt wird.

11. LGA-Bausteinbuchse (501) nach einem der Ansprüche 7 bis 10, wobei das Abdeckelement (508) Folgendes umfasst: eine Öffnung (516) zum Freilegen eines Teils des LGA-Bausteins (529), eine gekrümmte Fläche (572, 573), die sich von den Außenkanten (534, 535) des Abdeckelement (508) bis zu den gegenüberliegenden Endkanten (570) der Öffnung (568) erstreckt und so geformt ist, dass sie zur Seite des LGA-Bausteins hin konvex ist, und einen Druckausübungspunkt (570a), der an dem am meisten vorspringenden Abschnitt jeder gekrümmten Fläche (572, 573) angeordnet und dafür eingerichtet ist, den LGA-Baustein (529) zu pressen, wenn das Abdeckelement (508) geschlossen wird.

12. LGA-Bausteinbuchse (501) nach Anspruch 11, wobei die gekrümmte Fläche (572, 573) fortschreitend zunehmende Krümmungen hat und den größten Krümmungsradius an dem Druckausübungspunkt (570a) hat.

## Revendications

1. Douille (1) de boîtier en grille matricielle (LGA), comprenant:
un boîtier isolant rectangulaire (3, 120) comportant un grand nombre de cavités (128), recevant chacune un contact électrique; un élément de couverture (8) monté de manière pivotante sur une première extrémité (4) du boîtier isolant (3, 120); et un levier (12) monté de manière pivotante sur une deuxième extrémité (6), opposée à la première extrémité (4) du boîtier isolant (3, 120); où l'élément de couverture (8) est fermé, le boîtier LGA (200) placé sur le boîtier isolant (3, 120) est pressé contre les contacts électriques pour former des connexions électriques, une extrémité libre de l'élément de couverture fermé (8) étant verrouillée par le levier (12);
**caractérisée en ce que** le levier (12) est supporté de manière pivotante sur la deuxième extrémité (6), un élément de renforcement métallique (10) s'étendant entre la première extrémité (4) et la deuxième extrémité (6) étant agencé sur le côté inférieur du boîtier isolant (3, 120) et le boîtier LGA (200) et le boîtier isolant (3, 120) étant maintenus dans un état à association mutuelle étroite entre l'élément de renforcement métallique (10) et l'élément de couverture (8).

2. Douille de boîtier LGA (1) selon la revendication 1, dans laquelle l'élément de renforcement métallique (10) comprend une partie d'interverrouillage (14) formée d'une seule pièce avec celui-ci, la partie d'interverrouillage (14) servant à verrouiller le levier (12), avec le levier (12) et l'élément de couverture (8) dans un état engagé.

3. Douille de boîtier LGA (1) selon la revendication 1 ou la revendication 2, dans laquelle l'élément de renforcement métallique (10) est constitué par un composant d'une seule pièce s'étendant le long de l'ensemble de la périphérie du boîtier isolant (3, 120).

4. Douille de boîtier LGA (300) selon la revendication 1 ou la revendication 2, dans laquelle l'élément de renforcement métallique forme deux éléments (310a, 310b) fixés sur le boîtier isolant (303) le long de ses deux côtés, chacun s'étendant entre la première extrémité (304) et la deuxième extrémité (306).

5. Douille de boîtier LGA (501) selon l'une quelconque des revendications 1 à 4, dans laquelle l'élément de couverture (508) est supporté de manière pivotante (523, 526) par l'élément de renforcement métallique (510) au niveau de la première extrémité du boîtier isolant (505).

6. Douille de boîtier LGA selon la revendication 5, dans laquelle l'élément de couverture et l'élément de renforcement comportent une ouverture pour un arbre rotatif, l'élément de couverture étant monté de manière pivotante sur l'élément de renforcement par un élément d'arbre métallique séparé de l'élément de renforcement métallique.

7. Douille (501) de boîtier en grille matricielle (LGA), comprenant: un boîtier isolant rectangulaire (505) comportant un grand nombre de cavités (544), comprenant chacune un contact électrique (543); un élément de renforcement métallique (510) pour recevoir le boîtier isolant (505); un élément de couverture (508) monté de manière pivotante sur une première extrémité de l'élément de renforcement métallique (510); et un levier (512) monté de manière pivotante sur la deuxième extrémité, opposée à la première extrémité de l'élément de renforcement métallique (510);
dans laquelle, l'élément de couverture (508) étant fermé, le boîtier isolant (505) et le boîtier LGA (529) placé dans le boîtier isolant (505) sont retenus entre l'élément de renforcement métallique (510) et l'élément de couverture (508), une extrémité libre de l'élément de couverture fermé (508) étant verrouillée par le levier (512), le boîtier LGA (529) étant ainsi connecté électriquement aux contacts électriques (543).

8. Douille de boîtier LGA (501) selon la revendication 7, dans laquelle le levier (512) comprend une partie de verrouillage (515) pour verrouiller une extrémité libre de l'élément de couverture (508), une partie supportée en rotation (513), supportée en rotation par l'élément de renforcement métallique (510) sur les deux côtés de la partie de verrouillage (515), et une partie d'actionnement (512a) fléchie à un angle prédéterminé à l'écart de la partie supportée en rotation, de sorte que la partie d'actionnement (512a) peut être engagée dans une saillie d'interverrouillage (514) de l'élément de renforcement métallique (510); et
dans laquelle l'arbre s'étendant de la partie supporté en rotation (513) sur le côté de la partie d'actionnement vers la partie d'actionnement (512a) a une longueur suffisante pour permettre le déplacement de l'arbre associé au dégagement de la partie d'actionnement (512a) de la saillie d'interverrouillage (514), un espace (531) pour permettre le déplacement étant établi au niveau d'une position située sur le côté opposé à au moins la partie d'actionnement (512a) de l'arbre (512).

9. Douille de boîtier LGA (501) selon la revendication 8, dans laquelle un angle entre la partie d'actionnement (512a) et la partie de support de l'arbre (513) est ajusté de sorte à constituer un angle droit, un angle entre l'arbre (512b) et la partie d'actionnement (512a) étant ajusté de sorte à constituer un angle obtus α, l'espace (531) étant ainsi établi au niveau d'une position située sur le côté opposé à la partie d'actionnement (512a) de l'arbre (512).

10. Douille de boîtier LGA (501) selon l'une quelconque des revendications 7 à 9, dans laquelle le boîtier isolant (505) comporte plusieurs parties embouties (554), l'élément de renforcement métallique (510) comportant une partie d'engagement (528a) adapté pour s'engager dans la partie emboutie (554) et le boîtier isolant (505) étant fixé sur l'élément de renforcement métallique (510) par emboutissage de la partie emboutie (554).

11. Douille de boîtier LGA (501) selon l'une quelconque des revendications 7 à 10, dans laquelle l'élément de couverture (508) comprend: une ouverture (516) pour exposer une partie du boîtier LGA (529); une surface courbée (572, 573) s'étendant à partir des bords externes (534, 535) de l'élément de couverture (508) vers les bords d'extrémité opposés (570) de l'ouverture (568) et formée de sorte à être convexe vers le côté du boîtier LGA; et un point d'application de la pression (570a), agencé au niveau de la partie à débordement maximal de chaque surface courbée (572, 573) et adapté pour exercer une pression sur le boîtier LGA (529) lorsque l'élément de couverture (508) et fermé.

12. Douille de boîtier LGA (501) selon la revendication 11, dans laquelle la surface courbée (572, 573) comporte des courbures à accroissement progressif, le rayon maximal de courbure se situant au niveau du point d'application de la pression (570a).
